Europäisches Patentamt

European Patent Office

Office européen des brevets

(19)

(11) EP 1 465 471 A2

(12) **EUROPEAN PATENT APPLICATION**

(43) Date of publication:
06.10.2004 Bulletin 2004/41

(51) Int Cl.⁷: **H05K 3/46**, H05K 1/11

(21) Application number: 04007916.2

(22) Date of filing: 01.04.2004

(84) Designated Contracting States:
**AT BE BG CH CY CZ DE DK EE ES FI FR GB GR
HU IE IT LI LU MC NL PL PT RO SE SI SK TR**
Designated Extension States:
**AL HR LT LV MK**

(30) Priority: 03.04.2003 JP 2003099986
07.04.2003 JP 2003102606

(71) Applicant: **MATSUSHITA ELECTRIC INDUSTRIAL
CO., LTD.**
**Kadoma-shi, Osaka 571-8501 (JP)**

(72) Inventors:
• **Tomita, Yoshihiro**
**Osaka-shi, Osaka 534-0016 (JP)**

• **Nakamura, Tadashi**
**Suita-shi, Osaka 565-0817 (JP)**
• **Ishimaru, Yukihiro**
**Hirakata-shi, Osaka 573-0162 (JP)**
• **Sugaya, Yasuhiro**
**Toyonaki-shi, Osaka 560-0002 (JP)**
• **Honda, Kazuyoshi**
**Takatsuki-shi, Osaka 569-0056 (JP)**
• **Okazaki, Sadayuki**
**Katano-shi, Osaka 576-0054 (JP)**

(74) Representative: **Stippl, Hubert, Dipl.-Ing.**
**Hafner & Stippl,**
**Patentanwälte,**
**Schleiermacherstrasse 25**
**90491 Nürnberg (DE)**

(54) **Wiring board, method for manufacturing a wiring board and electronic equipment**

(57)    A wiring board that allows the high-density connection with a plurality of circuit boards within a limited area, a manufacturing method for the same and electronic equipment using the same are provided. A wiring board 100 includes: a plurality of conductive layers 1A to 1G each including one or more wirings for transmitting signals; and a plurality of insulation layers 2 for insulating the respective conductive layers 1A to 1G. The conductive layers 1A to 1G and the insulation layers 2 are laminated alternately, and each of the plurality of conductive layers 1A to 1G is provided with a terminal 1AT to 1GT at at least one of both ends. The terminals 1AT to 1GT are formed stepwise and separated by the insulation layers 2 in a cross-sectional shape of a lamination structure of the conductive layers 1A to 1G and the insulation layers 2.

FIG. 6A

EP 1 465 471 A2

**Description**

The present invention relates to a wiring board that electrically connects circuit boards to each other, a method for manufacturing the same and electronic equipment using the same.

Compact, thin and lightweight mobile electronic equipment such as a mobile phone, a notebook computer, a PDA and a digital video camera has been developed rapidly. Furthermore, the need for such electronic equipment with still higher performance and more functions is considerably increasing. For these reasons, microminiaturized semiconductor devices and circuit components and higher-density packaging technology for them have been developed dramatically.

In a field concerning the semiconductor devices, technologies for mounting a plurality of semiconductor chips as one package and for combining them into modules have been developed. As a result of such a high degree of integration, the number of pins also is being increased. In addition, in a field concerning the circuit components, the chip size is decreased significantly from $0.6 \times 0.3$ mm (0603) to $0.4 \times 0.2$ mm (0402).

A large number of high-density circuit boards that allow the high-density packaging of these semiconductor chips and circuit components have been supplied. For these high-density circuit boards, there are demands for coping with an increase in the speed of ICs mounted thereon, as well as having a still higher density by decreasing the size and increasing the number of input/output terminals. Then, it becomes an important challenge to connect the input/output terminals formed on such a high-density circuit boards to other circuit boards while keeping a high reliability.

For instance, in the case of a notebook computer and a mobile phone, etc., with a foldable configuration, input/output terminals, which are formed with a minute wiring pitch on the respective circuit boards of two constituting members, need to be electrically connected mutually while having a high connection reliability, and a wiring board for the connection is required to be made of a material and have a configuration that are resistant to bending.

To meet such demands, conventionally, a wiring board is configured so that a plurality of wirings are patterned on one side or both sides of a flexible board made of a polyimide film, and connection terminals are formed on both ends.

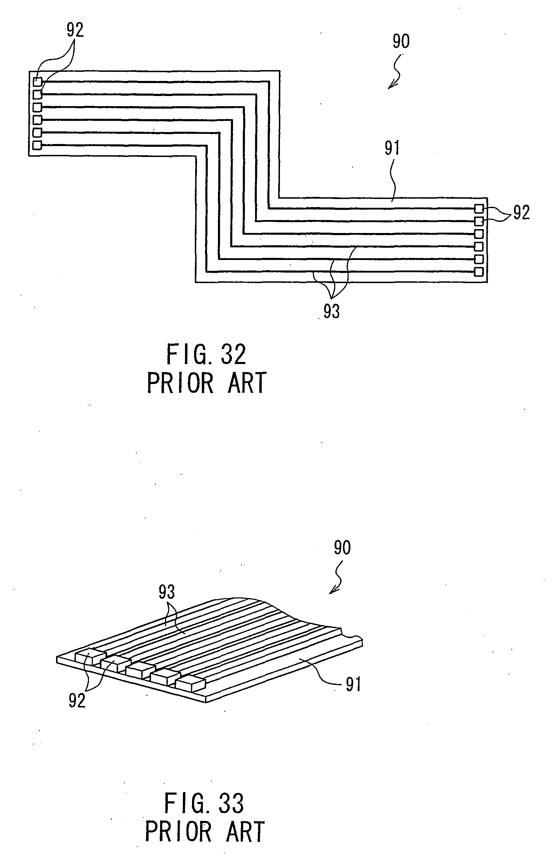

JP 2002-134845 A discloses a conventional wiring board. Fig. 32 is a plan view showing a configuration of the conventional flexible wiring board 90, and Fig. 33 is a perspective view partially showing the same. The flexible wiring board 90, for example, connects two circuit boards that are provided in two constituting members of a foldable type mobile phone. The flexible wiring board 90 is provided with an insulation board 91. The insulation board 91 has a shape that avoids the concentration of bending stress applied during a folding operation of the mobile phone. On the insulation board 91, a plurality of wirings 93 are formed in parallel with each other and with a predetermined pitch. At both ends of each wiring 93, terminals 92 are provided. Such a flexible wiring board 90 may be formed by a subtractive method (etching method), for example.

When the number of wirings 93 is increased in accordance with an increase in the number of the input/output terminals of the circuit board, the wirings 93 have to be formed on both faces of the insulation board 91 or a pitch of the wirings 93 has to be minute.

As described above, in accordance with the development of equipment and systems, the need is increasing for wiring boards capable of accommodating more wirings with high density. For that reason, as in the above-described conventional wiring board configuration, the way to form finer wirings and accommodate a large number of such wirings in one layer is a challenge for persons involved in the development and manufacturing of wiring boards. The persons involved in such a field are in the midst of the competition to develop a method for making the wirings minute.

The present inventors considered the following problems that generally have been considered in trying to make wirings minute:

(1) An increase in number of the wirings 93 causes an increase in area of the wiring board because the number of terminals 92 to be formed on the both ends of the wirings 93 is increased. This leads to a failure in the high-density connection with a plurality of circuit boards within a restricted area.
(2) Even when the pitch of the wirings 93 is made minute and the wirings 93 are formed on the both faces of the insulation board 91, there is a limit on an increase in density of the wirings within a restricted area.
(3) In the case where high frequency signals are to be transmitted, the skin effect of a conductor constituting the wiring 93 should be considered. For example, when signals at 500 MHz are transmitted, a depth of the skin of the conductor required for the transmission is 3 μm and when signals at 1 GHz are transmitted, a depth of the skin is 2 μm. Since the conductor of the wiring 93 formed on the conventional wiring board has a thickness of about 40 μm, only 2 to 3 μm out of the about 40 μm is used for the transmission of high frequency signals. Therefore, a transmission utilization factor per area of cross section of the conductor for transmitting high frequency signals is low.
(4) In order to avoid the concentration of bending stress applied during a folding operation of the mobile phone, the shape of the wiring board becomes complicated, and a length of the wirings becomes long.
(5) The wiring board needs to be customized according to the number of wirings, a terminal configuration and a shape of the wiring board, thus causing an increase in manufacturing cost.

Therefore, with the foregoing in mind, attention is given to these problems for making wirings minute and it is an object of the present invention to provide a wiring board that enables high-density connection with a plurality of circuit boards within a limited area from the viewpoint different from that for making wirings finer, a manufacturing method for the same and electronic equipment using the same.

A wiring board according to the present invention includes a plurality of conductive layers, each including one or more wirings for transmitting signals; and a plurality of insulation layers for insulating the respective conductive layers. The conductive layers and the insulation layers are laminated alternately, and each of the plurality of conductive layers is provided with a terminal at at least one of both ends. The terminals are formed stepwise and separated by the insulation layers in a cross-sectional shape of a lamination structure of the conductive layers and the insulation layers.

A manufacturing method for a wiring board according to the present invention is for manufacturing the wiring board including: a plurality of conductive layers each including one or more wirings for transmitting signals; and a plurality of insulation layers for insulating the respective conductive layers; wherein the conductive layers and the insulation layers are laminated alternately, and each of the plurality of conductive layers is provided with a terminal at at least one of both ends. The method includes the step of forming the terminals stepwise via the insulation layers in a cross-sectional shape of a lamination structure of the conductive layers and the insulation layers.

Another manufacturing method for a wiring board according to the present invention is for manufacturing the wiring board including: a plurality of conductive layers each including one or more wirings for transmitting signals; and a plurality of insulation layers for insulating the respective conductive layers, wherein the conductive layers and the insulation layers are laminated alternately. The method includes the step of forming the conductive layers and the insulation layers in an atmosphere at a reduced pressure below the atmospheric pressure.

Electronic equipment according to the present invention includes: a plurality of circuit boards; and a wiring board that connects the circuit boards. The wiring board is one according to the present invention.

Fig. 1A is a perspective view showing a configuration of a wiring board according to Embodiment 1, and Fig. 1B is a cross-sectional view of the same.

Fig. 2 is a cross-sectional view showing a configuration of another wiring board according to Embodiment 1.

Fig. 3 is a cross-sectional view showing a configuration of a wiring board according to Embodiment 2.

Fig. 4A is a perspective view showing a configuration of a wiring board according to Embodiment 3, and Fig. 4B is a cross-sectional view of the same.

Fig. 5 is a cross-sectional view showing a configuration of another wiring board according to Embodiment 3.

Fig. 6A is a cross-sectional view showing a configuration of still another wiring board according to Embodiment 3, and Fig. 6B is a plan view of the same. Fig. 6C is a cross-sectional view showing a further wiring board according to Embodiment 3. Fig. 6D is a cross-sectional view showing a configuration of a still further wiring board according to Embodiment 3, and Fig. 6E is a cross-sectional view showing a configuration of another wiring board according to Embodiment 3. Fig. 6F is a cross-sectional view showing a configuration of still another wiring board according to Embodiment 3.

Fig. 7A is an elevation view for explaining a wiring board according to Embodiment 4 and a connection state thereof, and Fig. 7B is a plan view of the same.

Fig. 8A is a plan view showing a configuration of a wiring board according to Embodiment 5, and Fig. 8B is a cross-sectional view of the same.

Fig. 9A is a plan view showing a configuration of another wiring board according to Embodiment 5, and Fig. 9B is a cross-sectional view of the same.

Fig. 10A is a plan view showing a configuration of a wiring board according to Embodiment 6, and Fig. 10B is a cross-sectional view of the same.

Fig. 11 is a plan view showing a configuration of another wiring board according to Embodiment 6.

Fig. 12A is a plan view showing a configuration of a wiring board according to Embodiment 7, and Fig. 12B is a cross-sectional view of the same.

Fig. 13A is a plan view showing a configuration of another wiring board according to Embodiment 7, and Fig. 13B is a plan view showing a configuration of still another wiring board according to Embodiment 7.

Fig. 14 is a cross-sectional view showing a configuration of a wiring board according to Embodiment 8.

Fig. 15 is a cross-sectional view showing a configuration of a wiring board according to Embodiment 9.

Fig. 16 is a cross-sectional view showing a configuration of a wiring board according to Embodiment 10.

Fig. 17A is a cross-sectional view showing a configuration of a wiring board according to Embodiment 11, and Fig. 17B is a plan view of the same.

Fig. 18 is a cross-sectional view showing a configuration of another wiring board according to Embodiment 11.

Fig. 19A is a plan view showing a configuration of still another wiring board according to Embodiment 11, and Fig. 19B is a cross-sectional view of the same.

Fig. 20A is a plan view showing a configuration of a further wiring board according to Embodiment 11, and Fig. 20B is a cross-sectional view of the same.

Fig. 21A is a plan view showing a configuration of a still further wiring board according to Embodiment 11, Fig. 21B is a cross-sectional view of the same, and Fig. 21C is another cross-sectional view of the same.

Fig. 22 is a plan view showing a configuration of another wiring board according to Embodiment 11.

Fig. 23Ais a plan view showing a configuration of still another wiring board according to Embodiment 11, and Fig. 23B is a cross-sectional view of the same.

Fig. 24A is a plan view showing a configuration of a further wiring board according to Embodiment 11, and Fig. 24B is a plan view showing a configuration of a still further wiring board according to Embodiment 11.

Fig. 25 is a cross-sectional view showing a configuration of a wiring board according to Embodiment 12.

Fig. 26 is a cross-sectional view showing a configuration of a wiring board according to Embodiment 13.

Figs. 27A to 27C are cross-sectional views showing a method for manufacturing the wiring board according to Embodiment 13.

Figs. 28A to 28D are cross-sectional views for explaining a manufacturing method of a wiring board according to Embodiment 14.

Fig. 29A is a cross-sectional view showing a configuration of a wiring board according to Embodiment 15, and Fig. 29B is a plan view of the same.

Fig. 30A is a cross-sectional view for explaining a configuration of a conventional resin board for packaging a semiconductor integrated circuit on a mother board, and Fig. 30B is a plan view of the same.

Fig. 31A is a schematic diagram for explaining a wiring board according to Embodiment 16 that is for connecting mother boards, and Fig. 31B is a schematic diagram for explaining a conventional wiring board that is for connecting the mother boards.

Fig. 32 is a plan view showing a configuration of a conventional flexible wiring board.

Fig. 33 is a perspective view partially showing the conventional flexible wiring board.

The present invention can provide a wiring board that enables high-density connection with a plurality of circuit boards within a limited area, a manufacturing method for the same and electronic equipment using the same.

The inventors of the present invention questioned the common sense of the person skilled in the art to make wirings minute so that a wiring board can accommodate a large number of wirings with high density, and, instead, conceived the new idea of accommodating a large number of wirings in a wiring board by laminating a large number of conductive layers, the idea being based on a lamination capacitor.

JP H11(1999)-147279 A discloses a lamination capacitor in which a large number of dielectric layer and electrode layers are laminated alternately. The dielectric layers and the electrode layers are formed as thin as possible in order to increase the capacity of the capacitor, and the number of the lamination of the dielectric layers and the electrode layers are as many as 1,000. Since this lamination capacitor is required simply to function as the capacitor, the electrode layers are laminated simply by changing their polarities alternately, and the leading-out of the electrode layers is carried out by forming an external electrode that is common to the electrode layers exposed at their cut edges. Therefore, since it is not possible to lead out the electrodes in the respective layers individually, it is difficult to employ this configuration as a wiring board. More specifically, since a lamination pitch of the respective electrode layers exposed at their edges is less than 1 $\mu$m, it is extremely difficult to lead out the individual wirings for each electrode layer from the cross section with such a minute pitch of the electrodes.

Then, the inventors of the present invention gave attention to a new configuration that allows thin film conductive layers that constitutes broad signal wirings and insulation layers for insulating the respective conductive layers to be laminated alternately in order to accommodate a large number of signal wirings therein with high density, and a new configuration for performing the lead-out from terminals individually for signal wirings of each conductive layer, so as to facilitate the terminal connection between the wiring board according to the following embodiments and another circuit board and the terminal connection between a semiconductor and an electronic component and the like.

By making the signal wiring broader, even when the conductive layers are made thin, a wiring resistance does not increase, and therefore a low-profile wiring board can be formed even when a large number of conductive layers are laminated. By exposing a surface of the respective conductive layers sequentially stepwise at one end and providing terminals at the exposed surfaces, the terminals can be formed easily for the respective conductive layers.

When minute wirings are used as in the conventional wiring board, even in the case where the wirings are exposed, unless a large land is provided at a terminal portion, it becomes difficult to conduct the alignment with the other circuit boards to be connected and the connection itself due to the minute wiring pitch. Further, the provision of the large land leads to a problem of inhibiting higher-density wiring, which is incompatible with the object.

On the other hand, in the following embodiments, broad signal wirings are used, and therefore the exposure of the surface of the signal wirings enables the provision of larger terminals, which facilitates the connection with the other circuit boards.

Furthermore, since a large number of conductive layers are laminated so as to allow the signal wirings with high density, an area of the exposed terminal portion can be broadened so as not to be incompatible with the higher-density wiring. Therefore, since there is no need to form minute via holes as in the conventional wiring board, the via hole connection and the bump connection that have a large aperture diameter and have a low profile, i.e., have a small aspect ratio, can be realized. In the case of the via hole connection with a large aspect ratio of its thickness exceeding its aperture diameter, stable connection cannot be secured, and a deterioration due to heat cycle and the like occurs, so that it becomes difficult to secure the reliability. On the other hand, the following embodiments enable via hole connection and bump connection with a small aspect ratio, and therefore the connection with stability and high reliability can be realized. Furthermore, since the conductive layers and the insulation layer are thin, a total thickness can be made much thinner, even when a large number of wirings are laminated, as compared with the conventional wiring board. This point also is an important factor that enables the connection with a small aspect ratio.

In the wiring board according to the following embodiments, the terminals are formed stepwise and separated by the insulation layers in a cross-sectional shape of a lamination structure of the conductive layers and the insulation layers. The stepped terminals enable high-density connection with a plurality of circuit boards with a high connection reliability. Furthermore, a short circuit between the terminals can be prevented effectively.

In this embodiment, it is preferable that the conductive layers and the insulation layers are formed in an atmosphere at a reduced pressure below the atmospheric pressure. This allows the formation of the conductive layers with a significantly small aspect ratio. This configuration enables a considerably small percentage of a deep portion in the conductive layer that does not function as a conductor due to the skin effect of the conductor, occurring when high frequency signals are to be transmitted. In addition, since the wirings are broad, a large area of the surface can function to be effective for the high frequency signals. As a result, a conductor loss can be avoided.

It is preferable that the plurality of conductive layers are three or more thin film conductive layers. This is because a larger number of the conductive layers laminated enables higher density wiring than the convention wiring board. Furthermore, when thirty or more thin film conductive layers are laminated, an especially good effect of realizing a flexible wiring board with higher density than the conventional wiring board can be obtained.

It is preferable that one or more conductive layers among the plurality of conductive layers include a plurality of wirings. This allows the number of wirings to be increased for each conductive layer, thus further enhancing the wiring density.

It is preferable that the number of wirings included in one of the plurality of conductive layers and the number of wirings included in another conductive layer of the plurality of conductive layers are different from each other. This configuration allows the widths of the wirings to be made different from one another for obtaining the optimum impedance depending on the frequency of high frequency signals to be transmitted.

It is preferable that at least two conductive layers among the plurality of conductive layers include a shield layer for shielding a wiring in another conductive layer sandwiched between the two conductive layers. Electromagnetic interference such as crosstalk, which tends to occur between the conductive layers provided with a high density, can be suppressed by the shield layer, which enables a decrease in the generation of noise.

It is preferable that one or more conductive layers among the plurality of conductive layers include a plurality of wirings, and each of the plurality of wirings includes the terminal. This allows for still higher-density connection with a plurality of circuit boards.

It is preferable that the terminals are arranged stepwise from a conductive layer laminated at the center toward conductive layers on both sides. This allows the connection with two circuit boards concurrently from the both sides of the wiring board, and therefore this configuration is effective for the miniaturization of electronic equipment.

It is preferable that the terminals are arranged in any one of manners that are along one vertical line, along one horizontal line and in a matrix form, when viewing from a lamination direction of the conductive layers and the insulation layers. This is for letting the terminals have a configuration in accordance with the arrangement of electrodes of a circuit board to be connected.

It is preferable that the terminals are arranged along a direction oblique to a longitudinal direction of the wirings, when viewing from a lamination direction of the conductive layers and the insulation layers. This is for letting the terminals have a configuration in accordance with the arrangement of electrodes of a circuit board to be connected.

It is preferable that the terminals are arranged in a V-letter shape, when viewing from a lamination direction of the conductive layers and the insulation layers. This is for letting the terminals have a configuration in accordance with the arrangement of electrodes of a circuit board to be connected, and also a plurality of terminals can be provided for one conductive layer. Furthermore, since the wirings in the different conductive layers that are laminated with each other can cross one another, the terminals provided asymmetrically on the both sides of the wiring board can be connected in the shortest distance without detouring the wirings.

It is preferable that the terminals each has a thickness larger than the conductive layer that is covered with the insulation layer. This is for enhancing the connection strength and connection reliability of the terminals.

It is preferable that bumps are formed on the respective terminals. This is for obtaining a significantly excellent connection reliability with electrodes of a circuit board.

It is preferable that each of the bumps has an electric connection face at its tip end, and the respective electric connection faces are formed to be coplanar. Even when there is a difference in level among the terminal planes of a circuit board to be connected, the difference in level among the terminals can be eliminated within a deformable range of the height of the bumps. This enables high-density connection with an excellent connection reliability.

It is preferable that the wiring board further includes a protective layer that covers the terminals; via hole conductors that are formed in the protective layer and connect with the respective terminals; and a plurality of electrodes that are formed on a surface of the protective layer and connect with the respective via hole conductors. With this configuration, the electrodes for the connection with the circuit board can be formed on the same plane, which can ease the conditions for connecting with the circuit board.

It is preferable that each of the terminals is formed so as to protrude and has an electric connection face at its tip end, and the respective electric connection faces are formed so as to be coplanar. Even when the number of wirings is increased and the number of conductive layers and insulation layers laminated is increased, this configuration can eliminate a difference in level between the terminals led out from a lower layer and the terminals led out from an upper layer, which enables high-density connection with an excellent connection reliability.

It is preferable that the conductive layers and the insulation layers are formed by at least one of a vapor deposition method, a sputtering method and a CVD method. The conductive layers can be formed so thin that a cross-sectional area in a deep portion of the conductive layer that becomes ineffective as the conductor can be reduced and that the entire conductive layers can function as the conductor that is effective for high frequency signals, even when the skin effect due to high frequency signals occurs.

According to the manufacturing method for a wiring board according to the following embodiments, the terminals are formed stepwise and separated by the insulation layers in a cross-sectional shape of a lamination structure of the conductive layers and the insulation layers. Therefore, the wiring board can be manufactured so that stepped terminals enable high-density connection with a plurality of circuit boards with a high connection reliability.

In this embodiment, it is preferable that the terminals are formed by plating while feeding electricity to the conductive layers at one end. This is for eliminating a difference in level between the terminals led out from a lower layer and the terminals led out from an upper layer.

It is preferable that each of the terminals is made up of a bump, and masking is applied to the conductive layers at one end using a mask having an aperture, and the bumps are formed by plating through the aperture of the mask while feeding electricity to the masked conductive layers at the one end. By adjusting the bumps in size, particularly in size of a height direction, differences in level among the bumps can be eliminated, thus enabling high-density connection with an excellent connection reliability.

It is preferable that that each of the terminals is made up of a bump, and the bumps are formed by depositing a conductor at one end of the conductive layers. This is for eliminating a difference in level between the terminals led out from a lower layer and the terminals led out from an upper layer.

It is preferable that a pressure is applied to tip ends of the respective bumps with flat plates so that the bumps are uniform in height to be coplanar. This is for adjusting the size of the bumps in the height direction.

According to the other manufacturing method for a wiring board of the following embodiments, the conductive layers and the insulation layers are formed in an atmosphere at a reduced pressure below the atmospheric pressure. This enables the formation of the conductive layers with a significantly small aspect ratio, and therefore a conductor loss based on the skin effect of the conductor, occurring when high frequency signals are to be transmitted, can be avoided.

The following describes embodiments of the present invention, with reference to the drawings. The present invention is not limited to the following embodiments. Furthermore, the present invention may include the combination of the following embodiments.

*Embodiment 1*

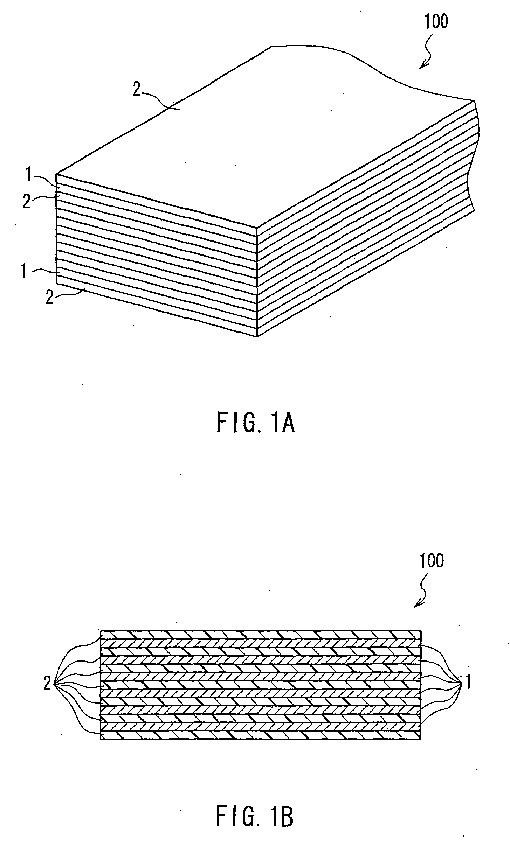

Fig. 1A is a perspective view showing a configuration of a wiring board 100 according to Embodiment 1, and Fig. 1B is a cross-sectional view of the same. The wiring board 100 includes a plurality of conductive layers 1 and a plurality of insulation layers 2 for insulating the respective conductive layers 1. The conductive layers 1 and the insulation layers 2 are laminated alternately. The conductive layers 1 and the insulation layers 2 are formed by a vacuum deposition method, sputtering, a CVD method or the like in environments at reduced pressures below the atmospheric pressure.

The conductive layers 1 and the insulation layers 2 have a cross-sectional shape with a dimension in a width direction being longer than that in a thickness direction. An aspect ratio representing a ratio of the length in the width direction with respect to the length in the thickness direction preferably is at least 1000. Especially, a thickness of the conductive layer 1 is formed so thin that a cross-sectional area in a deep portion of the conductive layer that becomes ineffective as the conductor can be reduced, and that the entire conductive layers can function as the conductor that is effective for high frequency signals, even when the skin effect due to high frequency signals occurs.

The thus formed wiring board 100 is manufactured as follows: firstly, a roller that rotates while being cooled is provided in an atmosphere at pressures below the atmospheric pressure. Then, a supporting base material is wrapped around the rotating roller. Next, a vapor deposition process for applying a metal, which has been vaporized by hitting a metal ingot with charged particles by plasma discharge and the like, on a surface of the supporting base material, and a vapor deposition process for applying a resin, which has been vaporized by heating means such as a heater, on the surface of the supporting base material are carried out repeatedly.

In the above-described method, the degree of vacuum is adjusted to about $2 \times 10^{-4}$ Torr so as to carry out the vapor deposition processes. This is because, in the case where the degree of vacuum does not reach such a level, it is difficult to generate vapor, and even if deposition can be carried out, the resulting film has an impurity, which may lead to problems in characteristics such as an electric conductivity and insulation properties. A temperature of the rotating roller may be set at about $0°C$ and the rotating speed may be set at about a circumferential velocity of 100 m/min.

The applied metal is composed of various materials such as precious metals including gold, silver, platinum, etc., copper, aluminum, tin, zinc, and the like. The applied resin preferably is made of a material containing acrylate resin and vinyl resin as a main component. Specifically, a (metha)acrylate monomer and a multifunctional vinyl ether monomer are preferable and, among them, cyclohexane dimethanol divinyl ether monomer, cyclopentadiene dimethanol diacrylate and the like, or a monomer obtained by substitution of hydrocarbon radicals of these monomers, are particularly preferable in terms of electrical characteristics, heat resistance properties and a stability.

Although a thickness of the supporting base material used in the above-described manufacturing method is not limited especially, when the supporting base material is composed of a material with a large tensile strength, e.g., polyimide, polyethylene terephthalate and polyethylene naphthalate, the supporting member can be made thin. The supporting base material may be not peeled off but used as a multilayered wiring board.

Although the thicknesses of the applied insulation layers 2 and the conductive layers 1 are not limited especially, they preferably are made thinner in order to suppress a total thickness of the wiring board. However, as the layers are made thinner, a resistance value thereof increases. Therefore, in such a case, a width therefore needs to be increased so as to suppress the increase in resistance value.

In order to transmit high frequency signals at 1 GHz or higher based on the skin current effect, a thickness of the conductive layer 1 of at least about 2 µm is sufficient. As the frequency of signals to be transmitted becomes higher, the thickness of the conductive layer 1 can be made thinner based on the skin current effect. Thus, the wiring board 100 according to Embodiment 1 has a particularly good effect that, as the frequency of signals to be transmitted becomes higher, a total thickness of the wiring board can be made thinner.

As for the thickness of the insulation layer 2, it has to be adjusted at a predetermined thickness with consideration given to impedance matching, especially when high frequency signals are to be transmitted. Needless to say, in such a case, the width of the conductive layer 1 becomes important. Needless to say, when a current and a voltage of signals to be transmitted are large, an increase in thickness of the insulation layer 2 leads to enhanced reliability.

The wiring board 100 according to Embodiment 1 was manufactured so that each conductive layer 1 had a thickness of about 0.7 µm and each insulation layer 2 had a thickness of about 0.5 µm, and the conductive layers 1 and the insulation layers 2 have a width of 5 mm. In the following Embodiments 2 or later, conductive layers and insulation layers laminated alternately were manufactured by a method similar to the above-described method.

The conventional flexible wiring board has a configuration in which a 35-µm thick copper foil conductor is bonded on a 25-µm thick polyimide film using a 20-µm thick adhesive layer, the copper foil is subjected to patterning, and further a 25-µm thick polyimide film is attached thereto using a 20-µm thick adhesive layer so that either surface of the copper foil pattern is sandwiched between the polyimide film. The total thickness of this conventional flexible wiring board exceeds 100 µm, so that a multilayered wiring having a lamination of only two layers of the flexible wiring boards has a total thickness exceeding 200 µm. It is known theoretically that the bending rigidity of a plate form material is increased in proportion to the cube of a thickness of the plate. When the total thickness of the flexible wiring board exceeds 200 µm, the bending rigidity thereof increases rapidly and a flexibility thereof is lost. When the flexible wiring board with a total thickness exceeding 200 µm is bent forcibly, a distortion of a surface increases, resulting in a break or a deterioration of the wirings.

On the other hand, the wiring board according to Embodiment 1 has a total thickness of 196.5 µm thinner than 200 µm, even when thirty conductive layers each having a thickness of 1.5 µm and thirty-one insulation layers each having a thickness of 5 µm are laminated alternately, for example. Therefore, the flexibility can be maintained even when thirty conductive layers are laminated. Furthermore, even when conductive layers each having a thickness of 0.5 µm and insulation layers each having a thickness of 0.2 µm are laminated alternately so as to manufacture a 200-layered wiring board, a total thickness thereof is thinner than 150 µm. Therefore, the wiring board with an excellent flexibility can be obtained.

In a general wiring board, since it is impossible for one conductive layer to accommodate wirings that cross one another, these wirings have to be routed to detour around other lands and wirings so as not to cross one another. Therefore, the wiring flexibility is extremely restricted for a single-layer wiring board. In the case of the above-described conventional wiring board, which has only two-layered lamination, when a large number of wirings are to be formed, the restriction on the wiring flexibility remains large.

On the other hand, the wiring board according this embodiment allows thirty or more laminations as described above, and therefore the wiring flexibility is great even when a large number of wirings are to be formed.

In this way, according to Embodiment 1, a plurality of conductive layers 1 each including one or more wirings for transmitting signals and a plurality of insulation layers 2 for insulating the respective conductive layers 1 are laminated alternately. Therefore, the number of wirings for transmitting signals can be increased within a limited area. As a result, a wiring board with an increased wiring density can be provided.

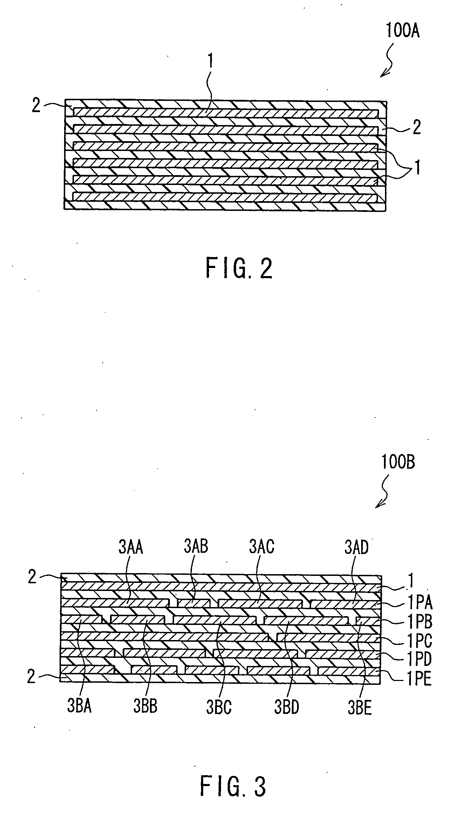

Fig. 2 is a cross-sectional view showing another wiring board 100A according to Embodiment 1. The same reference numerals are assigned for the same constituting elements as those in the above wiring board 100 described with reference to Fig. 1A and Fig. 1B. Therefore, the detailed explanations of these constituting elements are omitted.

As shown in Fig. 2, the entire surface of the conductive layers 1 may be covered with the insulation layer 2 or other insulation materials. The wiring board 100A may be manufactured according to the method of depositing the respective layers so that a width of the insulation layers 2 are made larger than a width of the conductive layers 1. The wiring board 100A may be manufactured by the formation of the wiring board 100 shown in Fig. 1B, followed by a process for covering the entire surface thereof with an insulation material.

*Embodiment 2*

Fig. 3 is a cross-sectional view showing a configuration of a wiring board 100B according to Embodiment 2. The above-described wiring board 100 according to Embodiment 1 has the one wiring for one layer configuration where each of the laminated conductive layers 1 forms one wiring. In Embodiment 2, a plurality of wirings are formed on one conductive layer.

As shown in Fig. 3, conductive layers 1, 1PA, 1PB, 1PC, 1PD and 1PE respectively have one or more wirings that are the same or different in number. Although the conductive layer 1 has the one wiring for one layer configuration, the conductive layer 1PA, for example, has four wirings 3AA, 3AB, 3AC and 3AD and the conductive layer 1PB has five wirings 3BA, 3BB, 3BC, 3BD and 3BE. The widths of the plurality of wirings formed on the respective conductive layers may be different from each other depending on a frequency of high frequency signals to be transmitted.

*Embodiment 3*

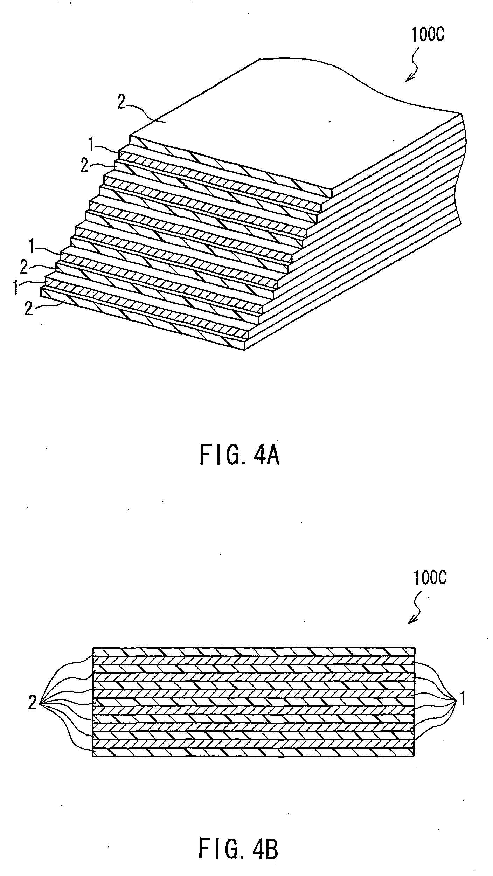

Fig. 4A is a perspective view showing a configuration of a wiring board 100C according to Embodiment 3, and Fig. 4B is a cross-sectional view of the same. The same reference numerals are assigned for the same constituting elements as those in the above wiring board 100 described with reference to Fig. 1A and Fig. 1B. Therefore, the detailed explanations of these constituting elements are omitted. A plurality of conductive layers 1 are formed stepwise at one end as is one end of a plurality of insulation layers 2.

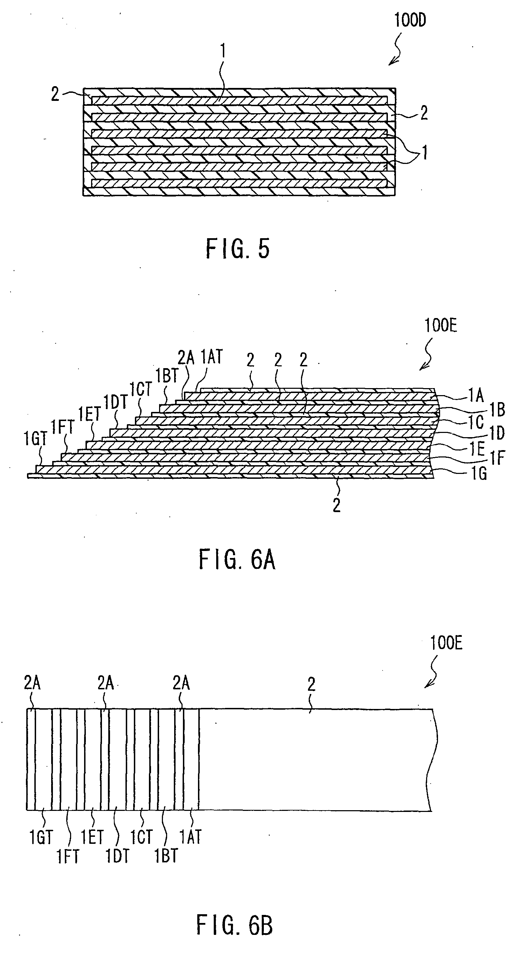

Fig. 5 is a cross-sectional view showing a configuration of another wiring board 100D according to Embodiment 3, taken along a cross section perpendicular to a longitudinal direction of conductive layers 1. Similarly to the wiring board 100C of Fig. 4A and Fig. 4B, a plurality of conductive layers 1 are formed stepwise at one end as is one end of a plurality of insulation layers 2. As shown in Fig. 5, the conductive layers 1 may be covered with the insulation layers 2. The wiring board 100D may be manufactured according to the method of depositing the respective layers so that the width of the insulation layers 2 is made larger than a width of the conductive layers 1. The wiring board 100D may be manufactured by the formation of the wiring board 100C shown in Fig. 4A, followed by a process for covering the entire surface thereof with an insulation material.

Fig. 6A is a cross-sectional view showing a configuration of still another wiring board 100E according to Embodiment 3, and Fig. 6B is a plan view of the same. The wiring board 100E includes a plurality of conductive layers 1A, 1B, 1C, 1D, 1E, 1F and 1G and a plurality of insulation layers 2 for insulating the respective conductive layers. The conductive layers 1A to 1G and the insulation layers 2 are laminated alternately. The conductive layers 1A to 1G are exposed at one end while being insulated with exposure portions 2A at one end of the insulation layers 2, and are formed stepwise as are the exposure portions 2A. On the entire surface of the exposure portions at one end of the conductive layers 1A, 1B, 1C, 1D, 1E, 1F and 1G, terminals 1AT, 1BT, 1CT, 1DT, 1ET, 1FT and 1GT respectively are provided. The conductive layers 1A to 1G and the insulation layers 2 are formed by a vacuum deposition method, sputtering, a CVD method or the like in an atmosphere at reduced pressures. Herein, an example where the conductive layers 1A to 1G have the one wiring for one layer configuration is described.

The terminals 1AT to 1GT and the exposure portions 2A can be obtained by repeatedly conducting: a process of evaporating the conductive layer while covering end portions of the insulation layers, to which the conductive layer does not need to be attached, with a resist so as to conduct the patterning; and a process of evaporating the insulation layer while covering end portions of the conductive layers, to which the insulation layer does not need to be attached, with a resist during the course of a procedure for multi-layering to evaporate repeatedly the insulation layers 2 and the conductive layers 1A to 1G in a vacuum. Finally, by stripping off these resists, the wiring board 100E can be obtained.

The resist may be composed of ester based, glycol based or fluorine based oils, and may be attached only to a portion required to be covered with the resist by an ink jet method in which liquid oil is injected from a nozzle. A conductive film is not formed at the end portions with this resist attached thereon, and an insulation layer is not formed at the end portions with this resist attached thereon. Thus, the terminals 1AT to 1GT can be formed stepwise via the insulation layers in a cross-sectional shape of the lamination structure of the conducive layers and the insulation layers. Note here that since different patterns need to be written for the respective layers depending on the configuration of the multilayered wiring board, it is preferable to apply the oil by the ink jet method.

Although the patterns are formed by the ink jet method in Embodiment 3, the present invention is not limited to this. Needless to say, similar patterns can be formed by other printing methods such as screen printing as well.

Terminals that are formed stepwise in a multilayered wiring board in Embodiments described later also may be formed by a similar method by altering the shape of patterns. The stepped configuration of Embodiment 3 can be applied to the above-described wiring board as in Embodiment 2 with a plurality of wirings formed in one conductive layer.

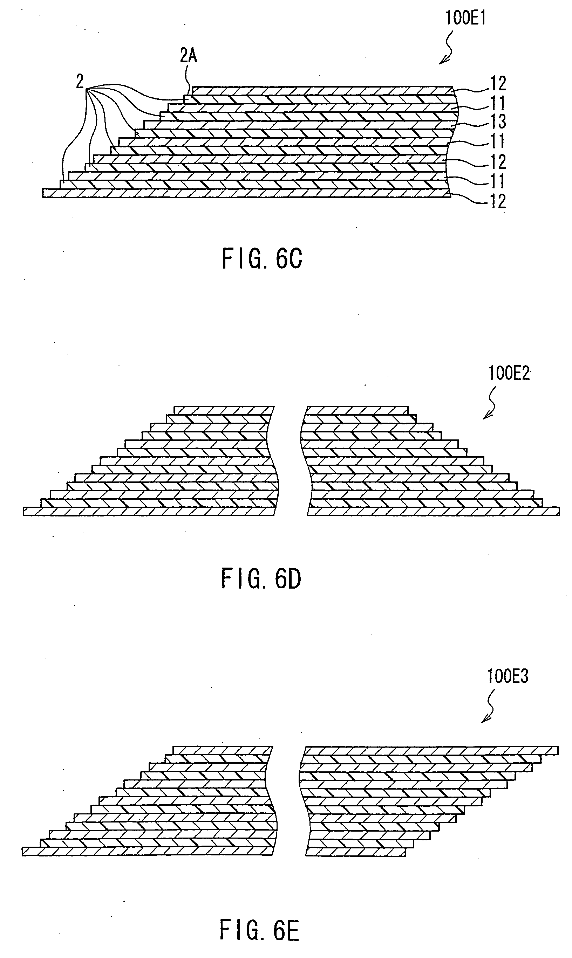

Fig. 6C is a cross-sectional view showing a further wiring board 100E1 according to Embodiment 3. In the wiring board 100E1, a ground layer 12, a signal wiring layer 11, a ground layer 12, a signal wiring layer 11, a power supply layer 13, a signal wiring layer 11 and a ground layer 12 are laminated in this stated order, and insulation layers 2 are formed between the respective layers. The ground layer 12, the signal wiring layer 11, the ground layer 12, the signal wiring layer 11, the power supply layer 13, the signal wiring layer 11 and the ground layer 12 are exposed at one end while being insulated with exposure portions 2A at one end of the insulation layers 2, and are formed stepwise as are the exposure portions 2A.

In this way, the signal wiring layer 11 is sandwiched between shield layers such as the ground layer 12 and the power supply layer 13, thereby suppressing the radiation of noise from the signal wiring layer 11 by the shield layers. Therefore, this configuration can prevent the noise from the signal wiring layer 11 from interfering with an operation of other circuits. The signal wiring layer 11 is protected by shielding layers, thus preventing a noise from the outside from adversely affecting the signal wiring layer 11. In addition, since the shield layer is formed between the signal wiring layers 11, crosstalk between the signal wiring layers 11 also can be prevented.

When the frequency of signals to be transmitted is very high, the influence of noise from the outside cannot be ignored. Therefore, the signal wiring layer 11 is sandwiched between the shield layers such as the ground layer 12 and the power supply layer 13 as shown in Fig. 6C, so as to obtain a wiring board that are significantly resistant to the noise. In the case where the conventional wiring board employs the above-described configuration, a thickness thereof increases, which becomes an obstacle of making electronic equipment smaller and thinner. However, since the configuration of Embodiment 3 allows the formation of a considerably thin wiring board, a thin wiring board that is resistant to a noise can be obtained.

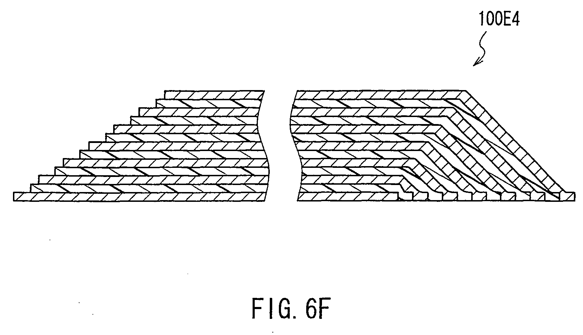

Fig. 6D is a cross-sectional view showing a configuration of a still further wiring board 100E2 according to Embodiment 3, and Fig. 6E is a cross-sectional view showing a configuration of another wiring board 100E3 according to Embodiment 3. Further, Fig. 6F is a cross-sectional view showing a configuration of still another wiring board 100E4 according to Embodiment 3.

As shown in Fig. 6D, the stepped shapes of the conductive layers and the insulation layers are formed symmetrical between one end and the other end, whereby the conductive layers and the insulation layers can be laminated so as to align the respective layers at their centers. Thus, the wiring board can be manufactured easily. Especially, sheet-form insulation layers can be laminated easily.

As shown in Fig. 6E, the conductive layers and the insulation layers with a uniform length are laminated so as to be shifted with a certain pitch, which facilitates the formation of the wiring board. Sheet-form conductive layers that have been cut to a certain length and sheet-form insulation layers that have been cut to a certain length may be laminated alternately so as to be shifted with a certain pitch.

In the case where the lamination is carried out by evaporation in a vacuum, the wiring board 100E4 may be manufactured by repeatedly using a mask having a certain aperture for forming the patterns of the respective layers as shown in Fig. 6F. In an example shown in Fig. 6F, since the lamination is carried out by shifting the aperture of the mask with a certain pitch, right ends of the second or upper layers are formed by the action of gravity to have a shape to extend obliquely down to the base face that supports the lowermost layer. Therefore, while the respective layers are formed stepwise at the end portions on the left side, the end portions on the right side are formed on the same plane as that of the outer surface of the lowermost layer.

Furthermore, in the case where lamination is carried out by conducting evaporation in a vacuum from the shorter insulation layers and conductive layers so that the state of Fig. 6D becomes turned upside down, both end portions are formed in a shape extending obliquely down to the base face that supports the lowermost layer and are formed on the same plane as that of the outer surface of the lowermost layer, as in the end portion on the right side of Fig. 6F.

### Embodiment 4

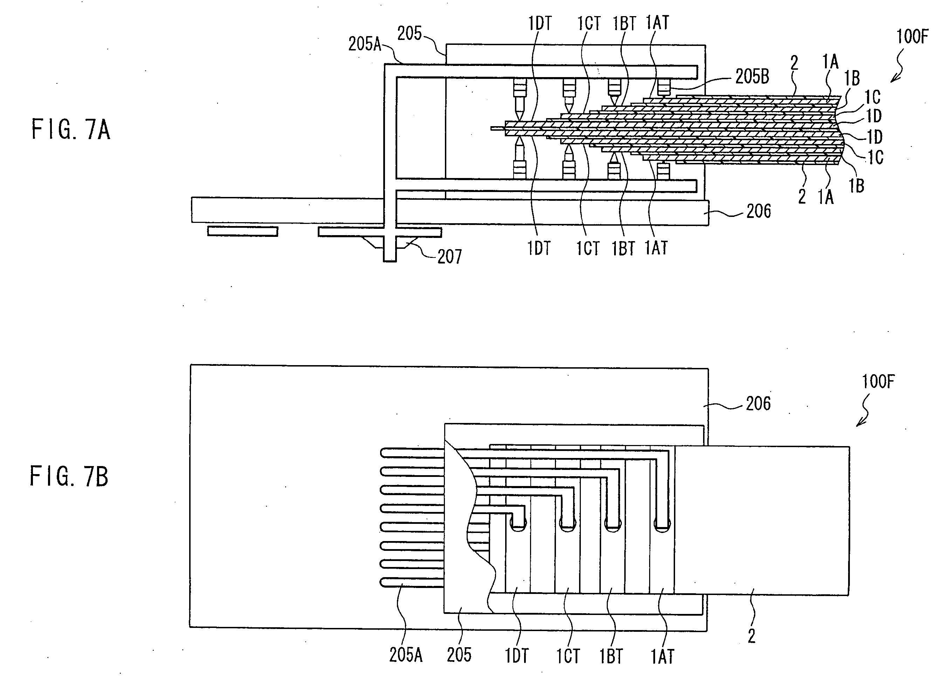

Fig. 7A is an elevation view for explaining a wiring board 100F according to Embodiment 4 and a connection state thereof, and Fig. 7B is a plan view of the same. In Embodiment 4, insulation layers 2 and conductive layers 1A to 1D are formed stepwise from a center portion to both upper and lower sides of Fig. 7A. In this way, one end of the wiring board 100F has a shape like an arrowhead. Terminals 1AT, 1BT, 1CT and 1DT are provided toward the both upper and lower sides. Thus, when the wiring board 100F is inserted and secured mechanically to a terminal socket 205 provided on a circuit board side, the connection reliability is improved.

At a connection portion 207 of a circuit board 206, a wire 205A is secured. When the wiring board 100F is inserted from the right side to the left side of Fig. 7A and Fig. 7B, the terminals 1AT, 1BT, 1CT and 1DT of the wiring board 100F are connected electrically with contact pins 205B provided in the wire 205A. At this time, the contact pins 205B have a configuration for pinching the wiring board 100F from upper and lower directions so as to apply a pressure. As a result, the connection reliability is improved.

Note here that although Fig. 7A and Fig. 7B illustrate an example where the terminals 1AT to 1DT are formed to be vertically symmetric, the present invention is not limited to this. The terminals may be formed to be vertically asymmetric.

### Embodiment 5

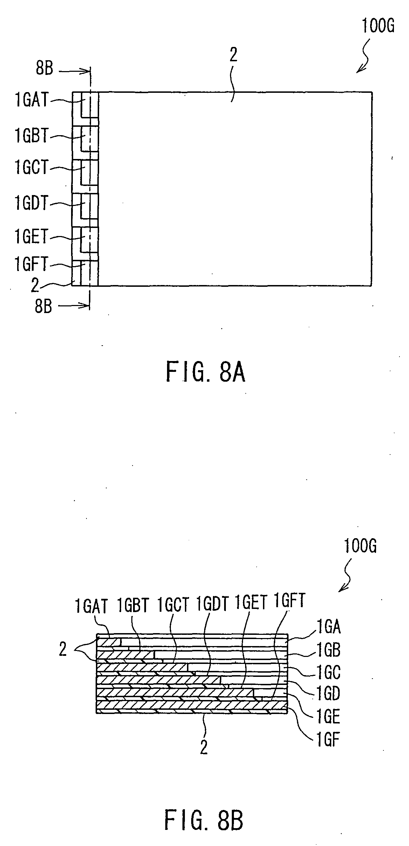

Fig. 8A is a plan view showing a configuration of a wiring board 100G according to Embodiment 5, and Fig. 8B is a cross-sectional view, taken along a line 8B-8B of Fig. 8A. The wiring board 100G includes a plurality of conductive layers 1GA, 1GB, 1GC, 1GD, 1GE and 1GF and a plurality of insulation layers for insulating the respective conductive layers. The conductive layers 1GA to 1GF and the insulation layers 2 are laminated alternately.

The laminated plurality of conductive layers 1GA, 1GB, 1GC, 1GD, 1GE and 1GF are provided with terminals 1GAT, 1GBT, 1GCT, 1GDT, 1GET and 1GFT, respectively, at one end. The terminals 1GAT to 1GFT of the conductive layers 1GA to 1GF are arranged along a width direction of the wiring board 100G as shown in Fig. 8A. When viewing along the cross-section 8B as shown in Fig. 8B, the terminals 1GAT to 1GFT are arranged stepwise. Such a configuration of the wiring board 100G is suitable for the case of the relatively small number of the conductive layers and the insulation layers laminated.

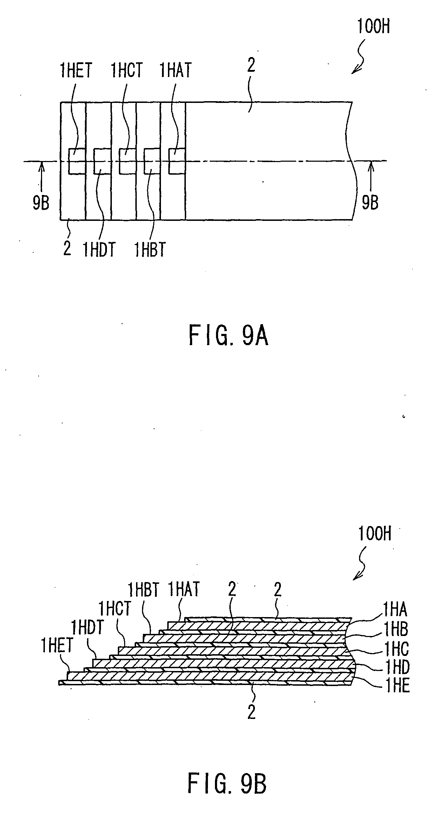

Fig. 9A is a plan view showing a configuration of another wiring board 100H according to Embodiment 5, and Fig. 9B is a cross-sectional view taken along a line 9B-9B of Fig. 9A. The wiring board 100H includes a plurality of conductive layers 1HA, 1HB, 1HC, 1HD and 1HE and a plurality of insulation layers 2 for insulating the respective conductive layers. The conductive layers 1HA to 1HE and the insulation layers 2 are laminated alternately.

The laminated plurality of conductive layers 1HA, 1HB, 1HC, 1HD and 1HE are provided with terminals 1HAT, 1HBT, 1HCT, 1HDT and 1HET, respectively, at one end. The terminals 1HAT to 1HET of the conductive layers 1HA to 1HE are arranged along a longitudinal direction of the wiring board 100H as shown in Fig. 9A. When viewing along the cross-section 9B as shown in Fig. 9B, the terminals 1HAT to 1HET are arranged stepwise.

In the wiring board 100E described above with reference to Fig. 6A and Fig. 6B, the terminals 1AT to 1GT are formed across the entire width of the wiring board 100E. Whereas, in the wiring board 100H shown in Fig. 9A and Fig. 9B, the terminals 1HAT to 1HET are formed at a central portion in the width direction of the wiring board 100H.

### Embodiment 6

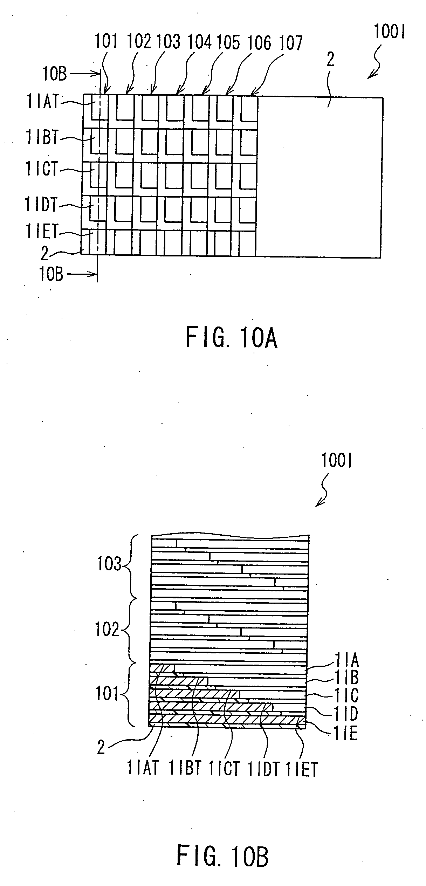

Fig. 10A is a plan view showing a configuration of a wiring board 100I according to Embodiment 6, and Fig. 10B is a cross-sectional view, taken along a line 10B-10B of Fig. 10A. In Embodiment 6, a plurality of terminals of conductive layers are arranged in a matrix form when viewing from the above of the wiring board 100I as shown in Fig. 10A.

The wiring board 100I includes lamination units 101 to 107. Each of the lamination units 101 to 107 has the same configuration as that of the wiring board 100G described above with reference to Fig. 8A and Fig. 8B.

For instance, the lamination unit 101 includes a plurality of conductive layers 1IA, 1IB, 1IC, 1ID and 1IE and a plurality of insulation layers 2 for insulating the respective conductive layers. The conductive layers 1IA to 1IE and the insulation layers 2 are laminated alternately. The laminated plurality of conductive layers 1IA, 1IB, 1IC, 1ID and 1IE are provided with terminals 1IAT, 1IBT, 1ICT, 1IDT and 1IET, respectively, at one end. The terminals 1IAT to 1IET of the conductive layers 1IA to 1IE are arranged along a width direction of the wiring board 100I as shown in Fig. 10A.

When viewing along the cross-section 10B as shown in Fig. 10B, the terminals 1IAT to 1IET are arranged stepwise.

Similarly to the lamination unit 101, terminals are formed in the conductive layers constituting the lamination units 102 to 107 as well. A group of these terminals is arranged in a matrix form as shown in Fig. 10A.

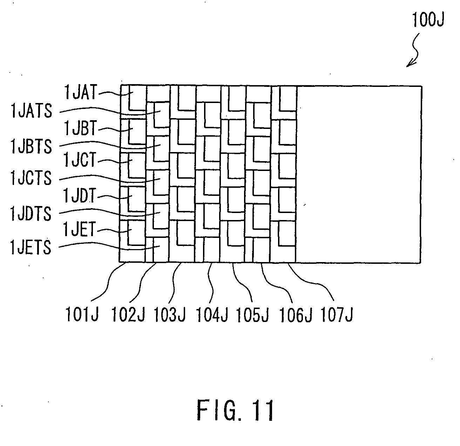

Fig. 11 is a plan view showing a configuration of another wiring board 100J according to Embodiment 6. A group of terminals formed in a matrix form may be arranged, as shown in Fig. 11, so as to be staggered for each of the lamination units 101J to 107J. The wiring board 100J includes the lamination units 101J to 107J. Each of the lamination units 101J to 107J has the same configuration as that of the wiring board 100G described above with reference to Fig. 8A and Fig. 8B.

For instance, the lamination unit 101J includes terminals 1JAT, 1JBT, 1JCT, 1JDT and 1JET, respectively, provided at one end of a plurality of laminated conductive layers. The lamination unit 102J includes terminals 1JATS, 1JBTS, 1JCTS, 1JDTS and 1JETS provided at one end of a plurality of conductive layers. The terminals 1JAT to 1JET of the lamination unit 101J and the terminals 1JATS to 1JETS of the lamination unit 102J are arranged at staggered positions with each other along a width direction of the wiring board 100J.

Although Embodiment 6 shows the example of the lamination units 101J to 107J each including five conductive layers, the present invention is not limited to this. Furthermore, the number of conductive layers included in the respective lamination units 101J to 107J may be different from each other.

*Embodiment 7*

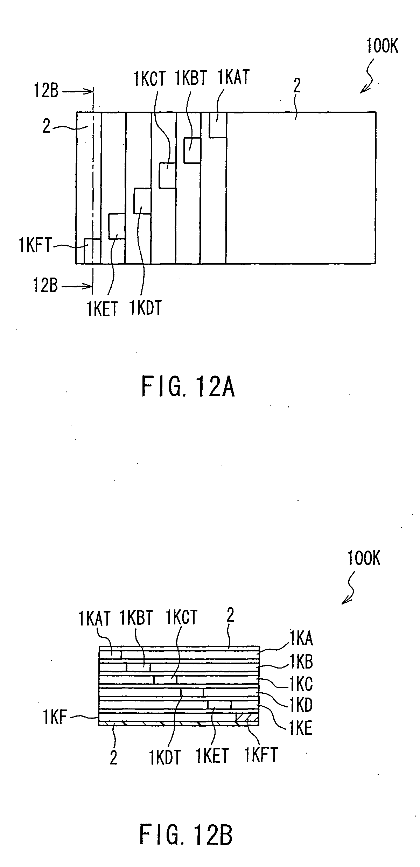

Fig. 12A is a plan view showing a configuration of a wiring board 100K according to Embodiment 7, and Fig. 12B is a cross-sectional view, taken along a line 12B-12B of Fig. 12A. Similarly to the above-described Embodiments 5 and 6, Embodiment 7 relates to the arrangement of terminals. As shown in Fig. 12A and Fig. 12B, conductive layers 1KA to 1KF are laminated with an insulation layer 2 interposed therebetween, and terminals 1KAT to 1KFT are formed at one end of the conductive layers so as to be shifted stepwise. When viewing from the lamination direction of the conductive layers and the insulation layers of the wiring board 100K as shown in Fig. 12A, the terminals 1KAT to 1KFT are arranged along a direction oblique to a longitudinal direction of the wiring board 100K. When viewing along the cross section 12B as shown in Fig. 12B, the terminals are arranged stepwise.

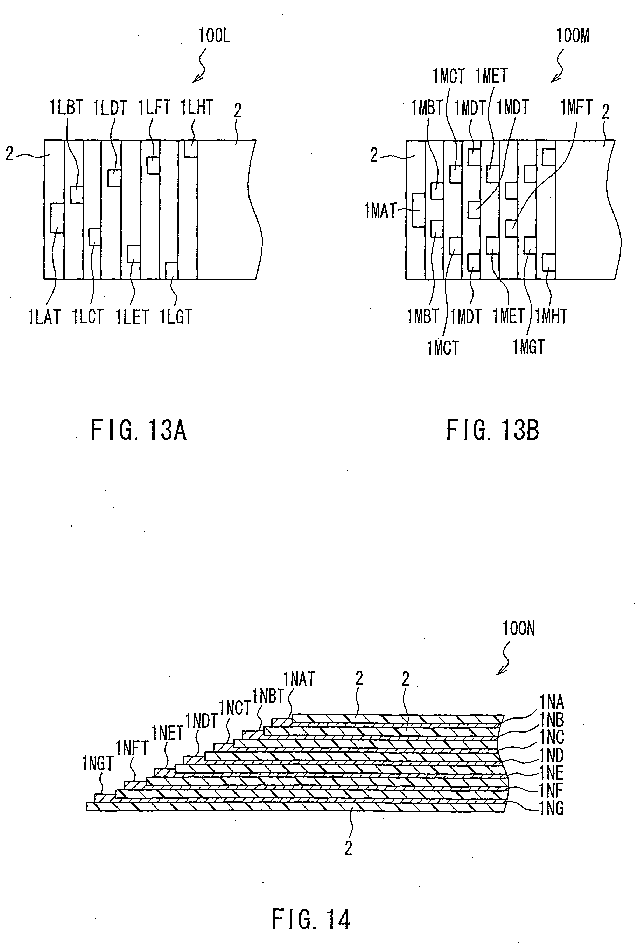

Fig. 13A is a plan view showing a configuration of another wiring board 100L according to Embodiment 7, and Fig. 13B is a plan view showing a configuration of still another wiring board 100M according to Embodiment 7. The wiring board 100L and the wiring board 100M are examples where a group of terminals is arranged in a stepped form that is different from the arrangement shown in Fig. 12A. In the wiring board 100L shown in Fig. 13A, terminals 1LAT, 1LBT, 1LCT, 1LDT, 1LET, 1LFT, 1LGT and 1LHT respectively are formed in a shape of the letter V, when viewing from the lamination direction of the conductive layers and the insulation layers.

In the wiring board 100M shown in Fig. 13B, one terminal 1MAT is formed on the lowermost conductive layer, and two terminals 1MBT are formed on a conductive layer thereon. Further, on a conductive layer formed thereon, two terminals 1MCT are formed, on a conductive layer thereon, three terminals 1MDT are formed, and on a conductive layer thereon, two terminals 1MET are formed. Moreover, on three conductive layers formed thereon, two terminals 1MFT, two terminals 1MGT and two terminals 1MHT respectively are formed. In this way, in a part of the plural conductive layers, there are a plurality of wirings and terminals provided for each layer.

With this configuration, terminals can be arranged and positioned freely so as to be shifted from each other, and a plurality of terminals in an arbitrary number can be formed on one conductive layer, and therefore this configuration is effective for enhancing the connection reliability. Note here that an area of the plurality of terminals provided in each conductive layer and a shape thereof may be the same or different.

*Embodiment 8*

Fig. 14 is a cross-sectional view showing a configuration of a wiring board 100N according to Embodiment 8. The wiring board 100N includes a plurality of conductive layers 1NA, 1NB, 1NC, 1ND, 1NE, 1NF and 1NG and a plurality of insulation layers 2 for insulating the respective conductive layers. The conductive layers 1NA to 1NG and the insulation layers 2 are laminated alternately. At one end of the conductive layers 1NA to 1NG, terminals 1NAT, 1NBT, 1NCT, 1NDT, 1NET, 1NFT and 1NGT respectively are formed. A thickness of the terminals 1NAT to 1NGT is larger than a thickness of the conductive layers 1NA to 1NG that are covered with the insulation layers 2. This configuration allows the connection reliability with other circuit boards to be improved.

The terminals 1NAT to 1NGT formed thicker than the conductive layers 1NA to 1NG can be composed of a material of the conductive layers 1NA to 1NG used as it is. The terminals 1NAT to 1NGT may be formed by depositing a metal such as gold, silver, tin and solder by vapor deposition, plating and the like.

**EP 1 465 471 A2**

*Embodiment 9*

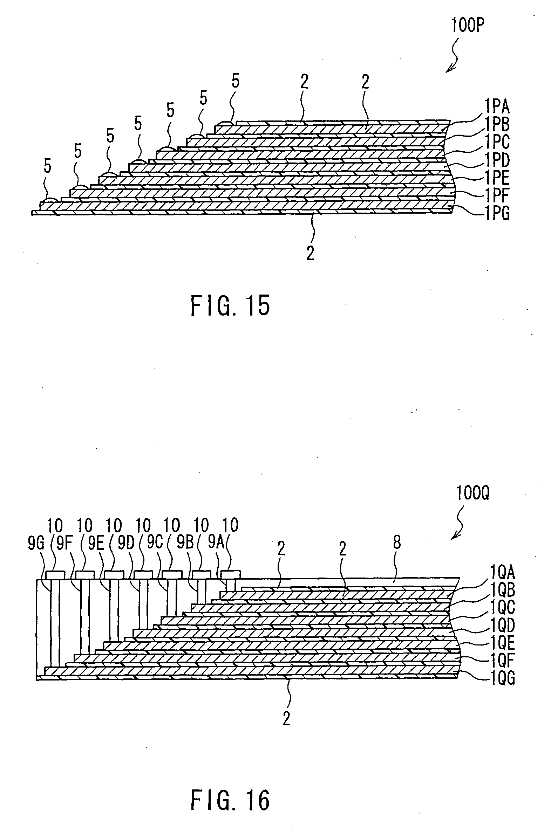

Fig. 15 is a cross-sectional view showing a configuration of a wiring board 100P according to Embodiment 9. The wiring board 100P includes a plurality of conductive layers 1PA, 1PB, 1PC, 1PD, 1PE, 1PF and 1PG and a plurality of insulation layers 2 for insulating the respective conductive layers. The conductive layers 1PA to 1PG and the insulation layers 2 are laminated alternately.

The conductive layers 1PA to 1PG are exposed at one end while being insulated with exposure portions at one end of the insulation layers 2, and are formed stepwise as are the exposure portions. At the one end of the conductive layers 1PA to 1PG, bumps 5 are formed respectively. A conductive material used for composing the bumps may be the same materials as those described in Embodiment 8.

*Embodiment 10*

Fig. 16 is a cross-sectional view showing a configuration of a wiring board 100Q according to Embodiment 10. The wiring board 100Q includes a plurality of conductive layers 1QA, 1QB, 1QC, 1QD, 1QE, 1QF and 1QG and a plurality of insulation layers 2 for insulating the respective conductive layers. The conductive layers 1QA to 1QG and the insulation layers 2 are laminated alternately. The one ends of the conductive layers 1QA to 1QG are insulated with one end of the insulation layers and are formed stepwise as are the one ends of the insulation layers 2. At exposure portions at the one end of the conductive layers 1QA to 1QG, terminals are provided respectively.

The wiring board 100Q further includes a protective layer 8 for covering the respective terminals, via hole conductors 9A, 9B, 9C, 9D, 9E, 9F and 9G that are formed in the protective layer 8 for the connection with the respective terminals, and a plurality of electrodes 10 that are formed on a surface of the protective layer 8 and connect with the respective via hole conductors 9A to 9G.

The via hole conductors 9A to 9G can be obtained by, after the formation of the protective layer 8, boring holes in the protective layer 8 by laser hole processing and the like, filling the holes with a conductive paste, followed by curing the conductive paste, or by plating with a conductor. Note here that, needless to say, these via hole conductors 9A to 9G can be formed by methods other than that.

With this configuration of the wiring board 100Q, many terminals of the wiring board can be formed as coplanar electrodes. Therefore, connection with other circuit boards can be established easily, and the connection reliability can be enhanced. Note here that bumps similar to Embodiment 9 may be formed on the respective electrodes 10.

Although Embodiment 10 shows the case where the outermost layer is the insulation layer 2, the present invention is not limited to this. The outermost layer may be a conductive layer so as to constitute a shield layer, in order that the shield connection with a main body can be established easily.

*Embodiment 11*

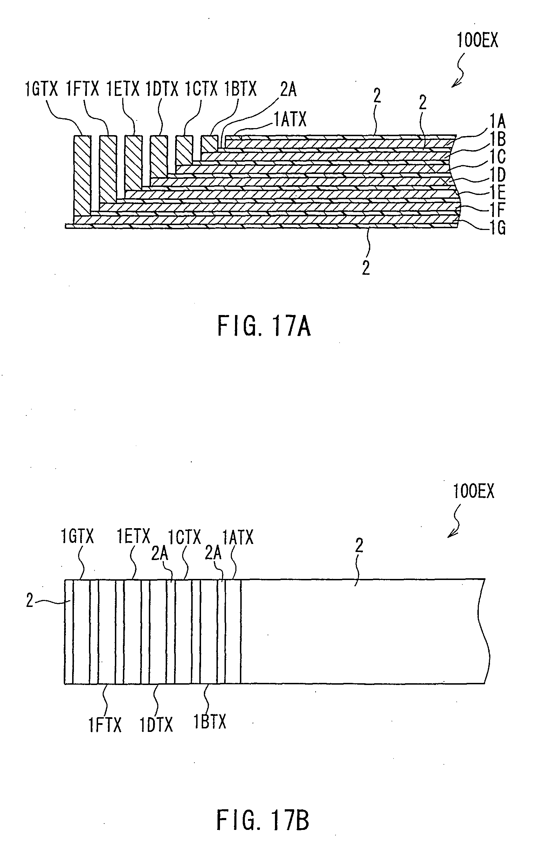

Fig. 17A is a cross-sectional view showing a configuration of a wiring board 100EX according to Embodiment 11, and Fig. 17B is a plan view of the same. The same reference numerals are assigned for the same constituting elements as those in the above wiring board 100E described with reference to Fig. 6A and Fig. 6B. Therefore, the detailed explanations of these constituting elements are omitted.

The wiring board 100EX includes a plurality of conductive layers 1A, 1B, 1C, 1D, 1E, 1F and 1G and a plurality of insulation layers 2 for insulating the respective conductive layers. The conductive layers 1A to 1G and the insulation layers 2 are laminated alternately. The conductive layers 1A to 1G are exposed at one end while being insulated with exposure portions 2A at one end of the insulation layers 2, and are formed stepwise as are the exposure portions 2A. Such a stepped configuration of the one end of the conductive layers and the exposure portions 2A can be formed by the method described above with reference to Fig. 6A of patterning while covering with a resist.

On the entire face of the exposure portions at one end of the conductive layers 1A, 1B, 1C, 1D, 1E, 1F and 1G, terminals 1ATX, 1BTX, 1CTX, 1DTX, 1ETX, 1FTX and 1GTX are formed respectively so as to protrude. The terminals 1ATX to 1GTX respectively have electric connection faces formed for the connection with terminals of a circuit board, and the respective electric connection faces are formed so as to be coplanar with a surface of an insulation layer 2 on the outside of the conductive layer 1A.

The terminals 1ATX to 1GTX are formed by providing plating at the exposure portions at one end of the conductive layers 1A to 1G while a current having a desired current density is supplied to the conductive layers 1A to 1G. The terminals 1ATX to 1GTX generally are made of the same material as that of the conductive layers 1A to 1G, or may be formed by depositing a metal such as gold, silver, tin and solder.

Although Embodiment 11 shows the one wiring for one layer configuration where one conductive layer includes one wiring, the configuration of one layer having plural wirings also is possible.

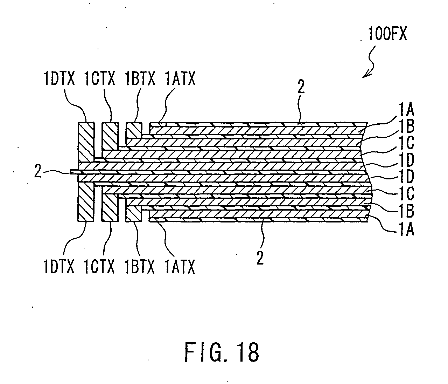

Fig. 18 is a cross-sectional view showing another wiring board 100FX according to Embodiment 11. The same reference numerals are assigned for the same constituting elements as those in the above wiring board 100F described with reference to Fig. 7A and Fig. 7B. Therefore, the detailed explanations of these constituting elements are omitted.

In the wiring board 100FX shown in Fig. 18, insulation layers 2 and conductive layers 1A to 1D are formed stepwise from a central portion toward both upper and lower sides. Then, terminals 1ATX, 1BTX, 1CTX and 1DTX are provided so as to protrude toward the both upper and lower sides. The terminals 1ATX to 1GTX respectively have electric connection faces formed for the connection with terminals of a circuit board, and the respective electric connection faces are formed so as to be coplanar with surfaces of the insulation layers 2 on the outside of both conductive layers 1A.

In this way, the terminals 1ATX to 1GTX are arranged on the both upper and lower sides, and therefore when the wiring board 100FX is inserted and secured mechanically to a terminal socket, not illustrated, provided on a circuit board side, the connection reliability is improved. Although Fig. 18 illustrates an example where the terminals 1ATX to 1DTX are formed to be vertically symmetric, the terminals 1ATX to 1DTX may be arranged to be vertically asymmetric.

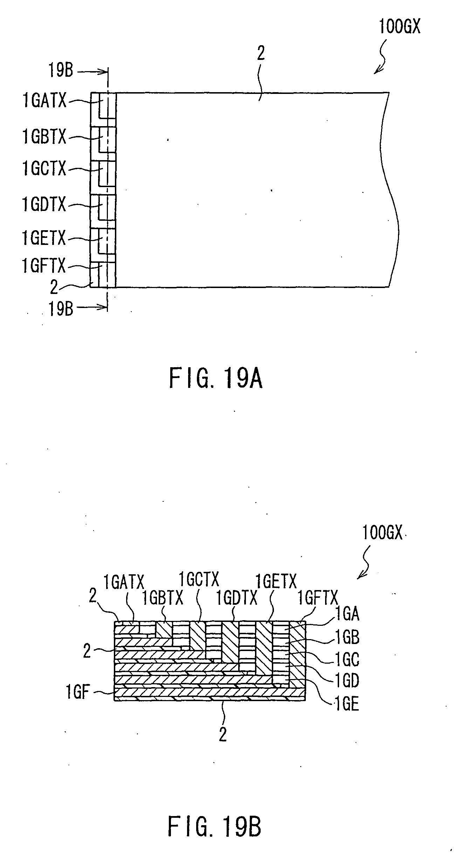

Fig. 19A is a plan view showing a configuration of still another wiring board 100GX according to Embodiment 11, and Fig. 19B is a cross-sectional view taken along a line 19B-19B of Fig. 19A. The same reference numerals are assigned for the same constituting elements as those in the above wiring board 100G described with reference to Fig. 8A and Fig. 8B. Therefore, the detailed explanations of these constituting elements are omitted.

The wiring board 100GX includes a plurality of conductive layers 1GA, 1GB, 1GC, 1GD, 1GE and 1GF and a plurality of insulation layers for insulating the respective conductive layers. The conductive layers 1GA to 1GF and the insulation layers 2 are laminated alternately.

The laminated plurality of conductive layers 1GA, 1GB, 1GC, 1GD, 1GE and 1GF are provided with protruding terminals 1GATX, 1GBTX, 1GCTX, 1GDTX, 1GETX and 1GFTX, respectively, at one end.

The terminals 1GATX to 1GFTX respectively have electric connection faces formed at their tip ends for the connection with terminals of a circuit board, and the respective electric connection faces are formed so as to be coplanar with a surface of the insulation layer 2 on the outside of the conductive layer 1GA, as shown in Fig. 19B. When viewing from the lamination direction of the conductive layers and the insulation layers, the terminals 1GATX to 1GFTX are arranged along a width direction of the wiring board 100GX as shown in Fig. 19A. Such a configuration of the wiring board 100GX is suitable for the case where a relatively small number of the conductive layers and the insulation layers is laminated.

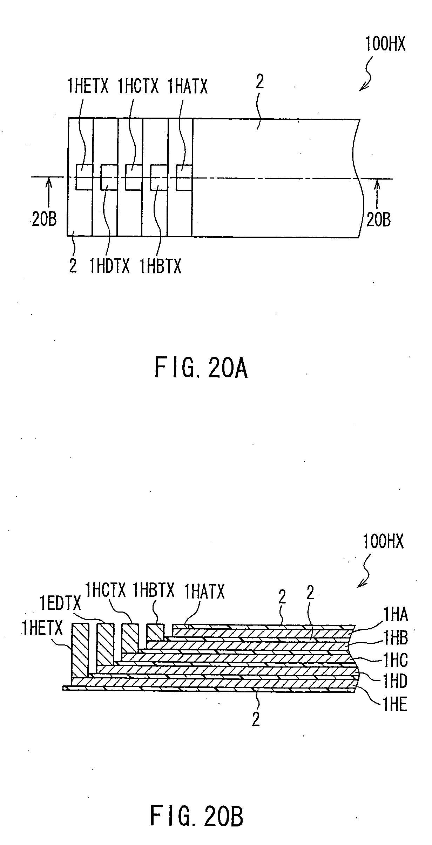

Fig. 20A is a plan view showing a configuration of a further wiring board 100HX according to Embodiment 11, and Fig. 20B is a cross-sectional view taken along a line 20B-20B of Fig. 20A. The same reference numerals are assigned for the same constituting elements as those in the above wiring board 100H described with reference to Fig. 9A and Fig. 9B. Therefore, the detailed explanations of these constituting elements are omitted.

The wiring board 100HX includes a plurality of conductive layers 1HA, 1HB, 1HC, 1HD and 1HE and a plurality of insulation layers 2 for insulating the respective conductive layers. The conductive layers 1HA to 1HE and the insulation layers 2 are laminated alternately. The laminated plurality of conductive layers 1HA, 1HB, 1HC, 1HD and 1HE are provided with protruding terminals 1HATX, 1HBTX, 1HCTX, 1HDTX and 1HETX, respectively, at one end.

The terminals 1HATX to 1HETX respectively have electric connection faces formed at their tip ends for the connection with terminals of a circuit board, and the respective electric connection faces are formed so as to be coplanar with a surface of the insulation layer 2 on the outside of the conductive layer 1HA, as shown in Fig. 20B. The terminals 1HATX to 1HETX are arranged along a longitudinal direction of the wiring board 100HX as shown in Fig. 20A. In the wiring board 100HX, the terminals 1HATX to 1HETX are formed at a central portion along a width direction of the wiring board 100HX.

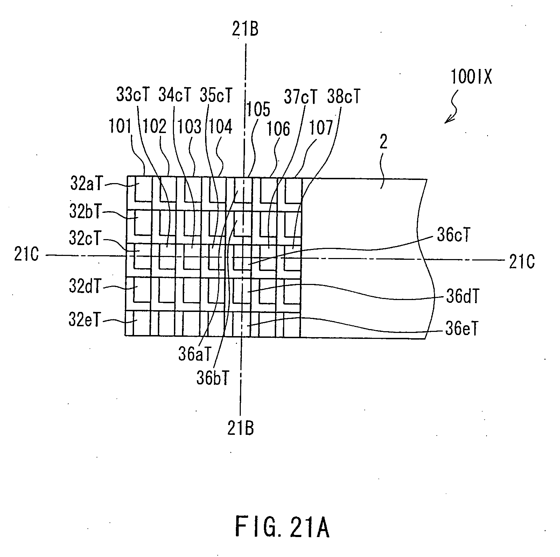

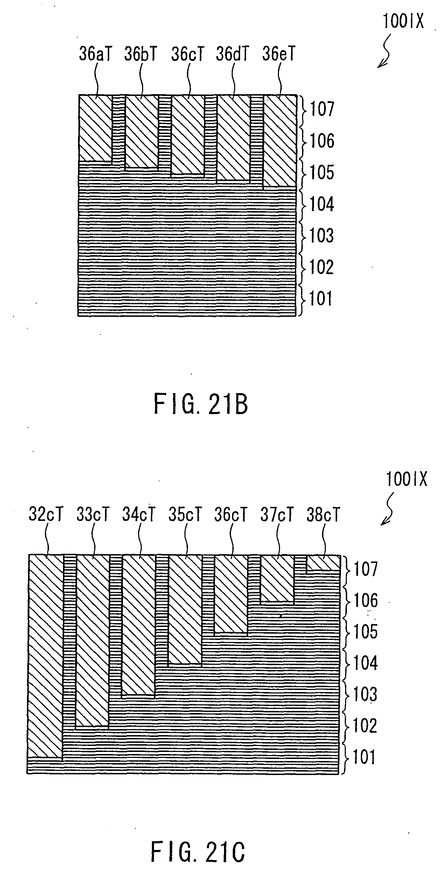

Fig. 21A is a plan view showing a configuration of a still further wiring board 100IX according to Embodiment 11, Fig. 21B is a cross-sectional view taken along a line 21B-21B of Fig. 21A, and Fig. 21C is a cross-sectional view taken along a line 21C-21C of Fig. 21A. The same reference numerals are assigned for the same constituting elements as above described with reference to Fig. 10A and Fig. 10B. Therefore, the detailed explanations of these constituting elements are omitted. The wiring board 100IX is configured with a plurality of lamination units that are the wiring boards 100GX shown in Fig. 19A and Fig. 19B, the plurality of lamination units being shifted every lamination unit.

The wiring board 100IX includes lamination units 101 to 107. Each of the lamination units 101 to 107 has the same configuration as that of the wiring board 100GX described above with reference to Fig. 19A and Fig. 19B.

For instance, at one end of five conductive layers in the lamination unit 101, five terminals 32aT, 32bT, 32cT, 32dT and 32eT are formed so as to protrude, and at one end of a plurality of conductive layers in the lamination unit 105, five terminals 36aT, 36bT, 36cT, 36dT and 36eT are formed so as to protrude. Similarly, at one end of five conductive layers in each of other lamination units 102, 103, 104, 106 and 107, five terminals are formed so as to protrude. As shown in Fig. 21C, terminals 32cT, 33cT, 34cT, 35cT, 36cT, 37cT and 38cT are arranged along the cross section 21C.

The respective terminals are arranged in a matrix form as shown in Fig. 21A, and each terminal has an electric connection face formed for the connection with a terminal of a circuit board. As shown in Fig. 21B and Fig. 21C, the electric connection faces of the respective terminals are formed so as to be coplanar with a surface of an insulation layer 2 on the outside of the wiring board 100IX.

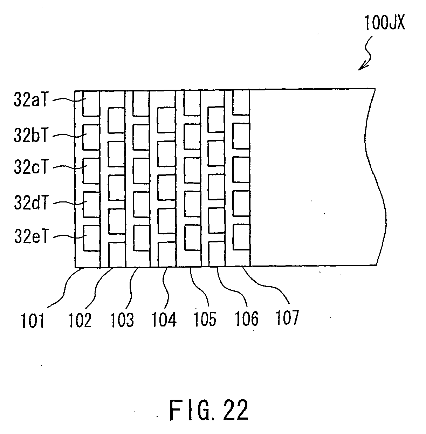

Fig. 22 is a plan view showing a configuration of another wiring board 100JX according to Embodiment 11. In the wiring board 100IX shown in Fig. 21A, a group of terminals is arranged in a matrix form. However, as shown in Fig. 22, the group of terminals may be arranged as shown in Fig. 22 so that the terminals are staggered for each of the lamination units 101 to 107 along a width direction. Although Embodiment 11 shows the example of the lamination units each including five conductive layers, the number of conductive layers included in the respective lamination units may be different from each other.

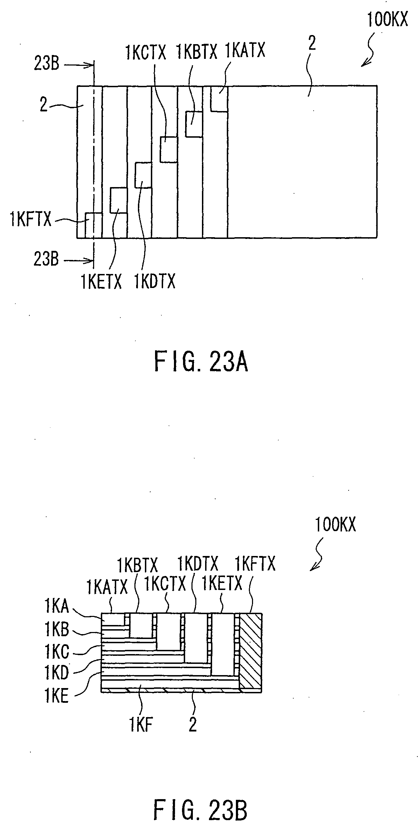

Fig. 23A is a plan view showing a configuration of still another wiring board 100KX according to Embodiment 11, and Fig. 23B is a cross-sectional view taken along a line 23B-23B of Fig. 23A. The same reference numerals are assigned for the same constituting elements as above described with reference to Fig. 12A and Fig. 12B. Therefore, the detailed explanations of these constituting elements are omitted.

Conductive layers 1KA to 1KE are laminated with insulation layers 2 interposed therebetween, and terminals 1KATX to 1KFTX are formed at one end of the conductive layers to protrude and be shifted stepwise. Each of the terminals 1KATX to 1KFTX has an electric connection face formed for the connection with a terminal of a circuit board, and as shown in Fig. 23B, the respective electric connection faces are formed so as to be coplanar with a surface of an insulation layer 2 on the outside of the conductive layer 1KA. When viewing from the lamination direction of the conductive layers and the insulation layers as shown in Fig. 23A, the terminals 1KATX to 1KFTX are arranged along a direction oblique to a longitudinal direction of the wiring board 100KX.

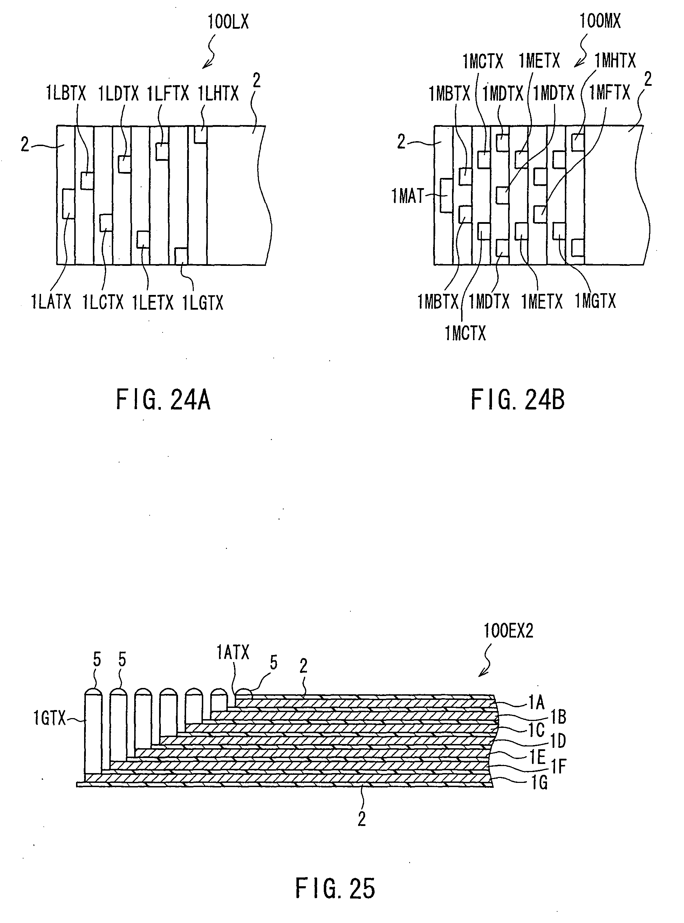

Fig. 24A is a plan view showing a configuration of a further wiring board 100LX according to Embodiment 11, and Fig. 24B is a plan view showing a configuration of a still further wiring board 100MX according to Embodiment 11.

In the wiring board 100LX shown in Fig. 24A, terminals 1LATX, 1LBTX, 1LCTX, 1LDTX, 1LETX, 1LFTX, 1LGTX and 1LHTX are formed so as to protrude and be in a shape of the letter V stepwise when viewing from the lamination direction of conductive layers and insulation layers. Each of the terminals 1LATX to 1LHTX has an electric connection face formed for the connection with a terminal of a circuit board, and the respective electric connection faces are formed so as to be coplanar with a surface of the outermost insulation layer 2.

In the wiring board 100MX shown in Fig. 24B, one terminal 1MATX is formed on the lowermost conductive layer, and two terminals 1MBTX are formed on a conductive layer thereon. Further, on a conductive layer formed thereon, two terminals 1MCTX are formed, on a conductive layer thereon, three terminals 1MDTX are formed, and on a conductive layer thereon, two terminals 1METX are formed. Moreover, on three conductive layers formed thereon, two terminals 1MFTX, two terminals 1MGTX and two terminals 1MHTX respectively are formed. In this way, in a part of the plural conductive layers, there are a plurality of wirings and terminals provided for one layer.

Each of the terminals 1MATX to 1MHTX has an electric connection face formed for the connection with a terminal of a circuit board, and the respective electric connection faces are formed so as to be coplanar with a surface of the outermost insulation layer 2.

With this configuration, terminals can be arranged and positioned freely so as to be shifted from each other, and a plurality of terminals arbitrary in number can be formed on one conductive layer, and therefore this configuration is effective for enhancing the connection reliability. Note here that an area of the plurality of terminals provided in each conductive layer and a shape thereof may be the same or different.

*Embodiment 12*

Fig. 25 is a cross-sectional view showing a configuration of a wiring board 100EX2 according to Embodiment 12. The same reference numerals are assigned for the same constituting elements as those in the above wiring board 100EX described with reference to Fig. 17A. Therefore, the detailed explanations of these constituting elements are omitted.

On terminals 1ATX to 1GTX, bumps 5 respectively are formed. A conductive material used for forming the bumps 5 may be the same material as that for the terminals 1ATX to 1GTX. The bumps may be formed on the terminals of the wiring boards with various configurations shown in Embodiment 11.

*Embodiment 13*

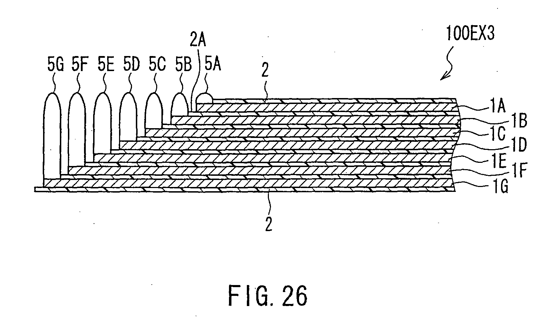

Fig. 26 is a cross-sectional view showing a configuration of a wiring board 100EX3 according to Embodiment 13. The same reference numerals are assigned for the same constituting elements as those in the above wiring board 100EX described with reference to Fig. 17A. Therefore, the detailed explanations of these constituting elements are omitted.

On exposure portions at one end of conductive layers 1A, 1B, 1C, 1D, 1E, 1F and 1G, bumps 5A to 5G are formed so as to protrude. The bumps 5A to 5G respectively have electric connection faces formed at their tip ends for the connection with terminals of a circuit board, and the respective electric connection faces are formed so as to be coplanar with a surface of an insulation layer 2 on the outside of the conductive layer 1A.

By adjusting the bumps 5A to 5G in size, particularly in size in the height direction, differences in level among the bumps 5A to 5G can be eliminated. The bumps 5A to 5G generally are made of the same material as that of the conductive layers 1A to 1G, or a metal such as gold, silver, tin and solder may be used.

In order to manufacture the bumps 5A to 5G, masking may be applied at the exposure portions at one end of the conductive layers 1A to 1G using a mask with an aperture, and plating may be provided through the aperture while a current having a desired current density is supplied to the respective conductive layers 1A to 1G.

A conductor may be deposited on the conductive layers 1A to 1G at one end so as to manufacture the bumps 5A to 5G. In Embodiment 13, a screen printing method was adopted to print a conductive paste, whereby a conductive substance was deposited so as to form the bumps. As the conductive paste, a material obtained by kneading powder made of silver and copper with a thermosetting epoxy resin generally is used, and a metal such as gold, tin and solder may be used.

Needless to say, manufacturing methods other than the printing method, e.g., a transfer method, spraying, vacuum deposition applied locally and wire bump, are applicable to deposit the conductive substance.

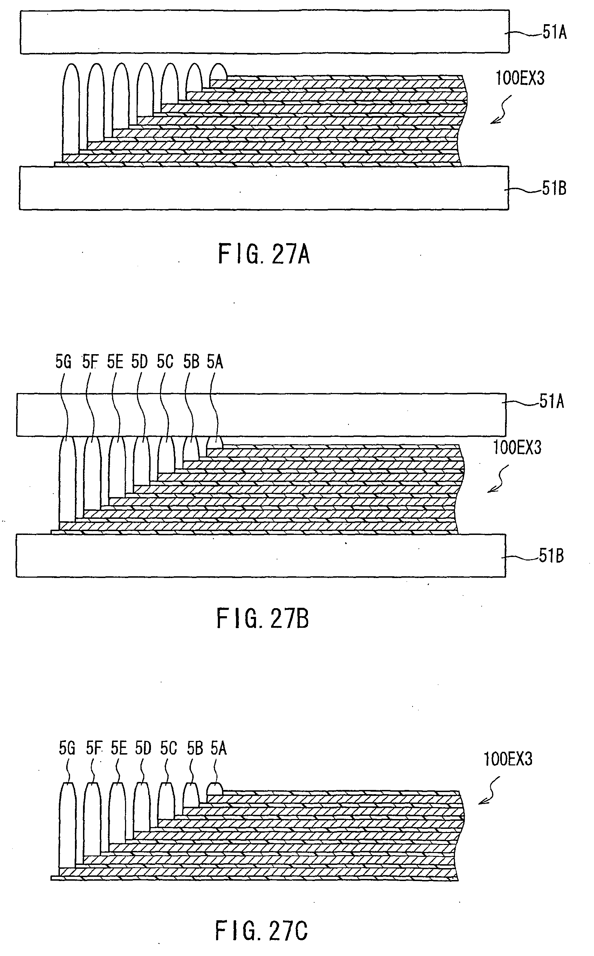

Figs. 2 7A to 27C are cross-sectional views showing a manufacturing method of the wiring board 100EX3 of Fig. 26. In the wiring board 100EX3, the bumps 5A to 5G provided on the conductive layers 1A to 1G at one end are formed in a relatively uniform shape by plating, wire bonding, printing, vacuum deposition or the like. Firstly, as shown in Fig. 27A, two plates 51A and 51B, which are surface plates whose surfaces are significantly accurate, are opposed at positions sandwiching the wiring board 100EX3 so as to be in parallel with each other. Then, as shown in Fig. 27B, the plates 51A and 51B are pushed closer to each other with a press machine, not illustrated, so as to allow a pressure to be applied to the wiring board 100EX3. This allows the bumps 5A to 5G to be deformed so as to be uniform with respect to their heights. Thereafter, the plates 51A and 51B are released, so that the wiring board 100EX3 having the bumps 5A to 5G with only a slight difference in level can be obtained as shown in Fig. 27C.

*Embodiment 14*

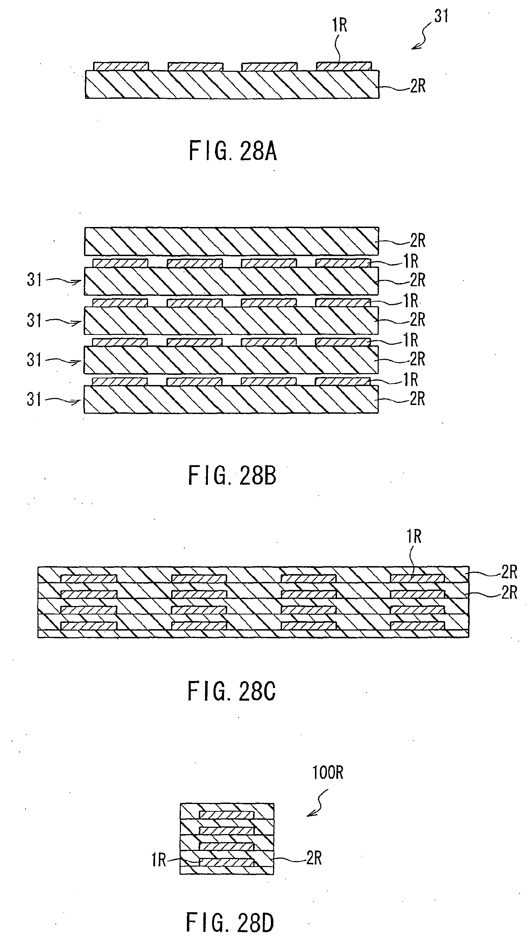

Figs. 28A to 28D are cross-sectional views for explaining a manufacturing method for a wiring board 100R according to Embodiment 14. In the above-described Embodiments 1 to 13, the conductive layers and the insulation layers are laminated by a deposition process in an atmosphere at a reduced pressure below the atmospheric pressure. However, the present invention is not limited to this. The conductive layers and the insulation layers may be laminated by the following method.

Firstly, as shown in Fig. 28A, a 0.6-$\mu$m thick copper thin film is formed by plating on one side of a 12-$\mu$m thick insulation layer 2R, and the copper thin film is wet-etched so as to be processed into a conductive layer 1R having a stripe shape with a wiring width of 4 mm, so that a film 31 is manufactured. The insulation layer 2R may be composed of a thermoplastic resin film, and this thermoplastic resin film contains liquid crystal polymers.

Then, as shown in Fig. 28B, a plurality of layers of the films 31 and the insulation layers 2R are laminated. Next, the thermoplastic resin film composing the insulation layer 2R is softened by pressing using heating rollers, not illustrated, so as to bond the respective films 31, whereby a multilayered thin film wiring board as shown in Fig. 28C can be formed. Since the insulation layers 2R between the conductive layers 1R are rolled spread by the pressing using the heating rollers, a thickness of the respective insulation layers 2R can be made 1.2 $\mu$m. The respective conductive layers 1R are covered with the insulation layers 2R. By cutting the insulation layer 2R at a position between the adjacent conductive layers 1R, a wiring board 100R as shown in Fig. 28D can be formed.

Also in the case of thusly manufacturing the wiring board by laminating the resin sheets of the insulation layers 2R, stepwise terminals can be formed easily. For instance, the conductive layer 1R of each film 31 may be formed to have a predetermined length such that the stepwise terminals are obtained at the time of pattern formation, and a large number of layers of the films 31 and the insulation layers 2R may be laminated. The terminals of the conductive layers 1R of the thus manufactured lamination have a stepped form. A pattern is not formed in the insulation layers 2R and the insulation layers 2R cover the entire surface of the conductive layers 1R.

Then, these insulation layers 2R may be treated as the protective layer 8 shown in Fig. 16 of Embodiment 10, and holes are bored in the insulation layers 2R so as to reach the conductive layers 1R by laser processing as in Embodiment 10. Next, the holes are filled with a conductive paste, followed by curing or plating is applied thereto so as to form via hole conductors, through which the lead-out from the stepwise terminals can be conducted.

Next, another method for forming stepwise terminals by using an resin sheet of an insulation layer will be described below. Conductive layers that are cut into the same length, made of copper foil, and insulation layers that are cut into the same length, made of a resin thin film sheet, are laminated so as to be shifted in a length direction and are attached by pressure, whereby terminals can be formed so as to be stepwise and be exposed as shown in Fig. 6E of Embodiment 3. Needless to say, the conductive layers and the insulation layers may have different lengths, and even when they are changed in length sequentially for each layer as shown in Fig. 6D, stepwise terminals can be formed.

The wiring board manufactured by such a method also exerts the effects described in the respective embodiments of the present invention.

*Embodiment 15*

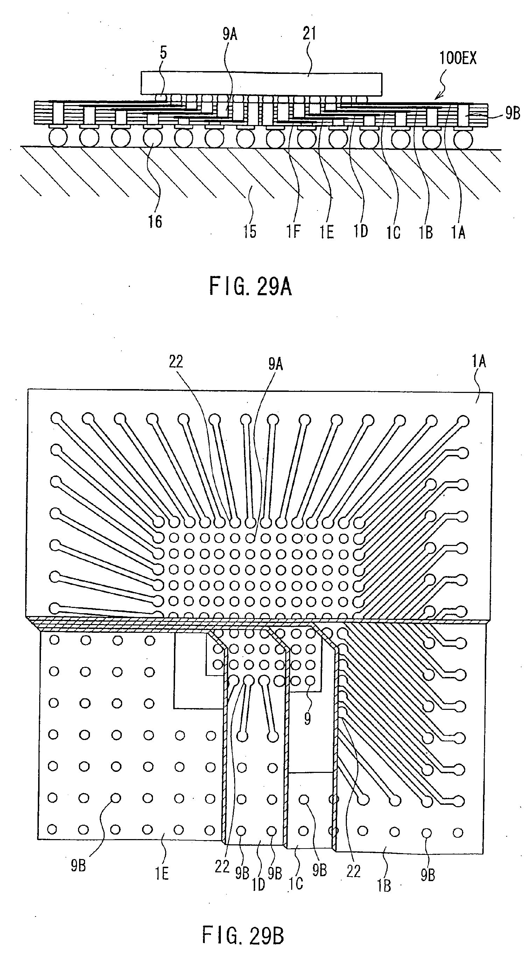

Fig. 29A is a cross-sectional view showing a connection structure of a wiring board 100EX according to Embodiment 15, and Fig. 29B is a plan view of the same. On the wiring board 100EX, a semiconductor integrated circuit 21 having electrode pads made up of bumps in an area array form is packaged. The wiring board 100EX is packaged on a mother board 15 by means of ball grid array (BGA) made up of solder balls 16.

The wiring board 100EX includes a plurality of conductive layers 1A, 1B, 1C, 1D, 1E and 1F and a plurality of insulation layers for insulating the respective conductive layers. The conductive layers 1A to 1F and the insulation layers are laminated alternately. Fig. 29B illustrates the conductive layers 1A, 1B, 1C and 1D with portions thereof broken away for the sake of clarity of a relationship between wirings on the upper conductive layer 1A and the internal conductive layers 1B, 1C, 1D and 1E.

Via hole conductors 9A are formed so as to extend from one end of each conductive layer to the corresponding bump 5, and the wiring board 100EX and the semiconductor integrated circuit 21 are connected electrically through the via hole conductors 9A. In order to carry out the leading-out from the bumps 5 in an area array form provided on the semiconductor integrated circuit 21, via hole conductors 9B are formed so as to extend from the other end of each conductive layer to the corresponding solder ball 16, whereby the wiring board 100EX and the mother board 15 are connected electrically through the via hole conductors 9B.

In order to carry out the leading-out from the bumps 5 in an area array form provided on the semiconductor integrated circuit 21, wirings for lands 22 on the outermost side are carried out in the uppermost conductive layer 1A of the wiring board 100EX, and lower conductive layers are used successively for the wirings for lands on a more inner side. Referring to Fig. 29B, the wirings formed in the uppermost conductive layer 1A allow the lands 22 on the outermost side in the area array to be lead out, and the wirings formed in the next conductive layers 1B allow the lands 22 on the second line from the outermost side in the area array to be lead out. Moreover, wirings formed on lower conductive layers 1C, 1D and 1E successively allow the lands on a more inner side to be lead out. Fig. 29A and Fig. 29B show an example of the 14 $\times$ 14 area array.

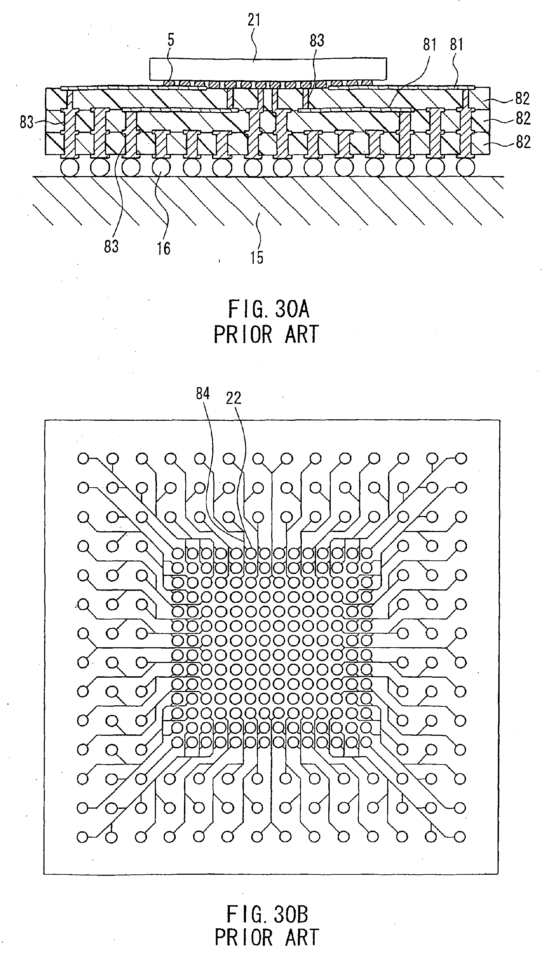

Fig. 30A is a cross-sectional view for explaining a configuration of a conventional resin board for packaging a semiconductor integrated circuit 21 on a mother board 15, and Fig. 30B is a plan view of the same. In the conventional resin board, wirings are led out from multiple pins of the semiconductor integrated circuit 21 via a small number of layers and minute wirings. The conventional resin board for a semiconductor package, typified by a build up board, requires significantly minute wirings and minute via hole connection to lead out the wirings from the multiple pins of the semiconductor integrated circuit 21. On the resin board, the semiconductor integrated circuit 21 having electrode pads made up of bumps 5 is packaged. The resin board is packaged on the mother board 15 via solder balls 16. In the resin board, three layers of insulation layers 82, two layers of conductive layers 81 and via hole conductors 83 are formed.

In land portions of an area array in a matrix form that are for accepting the bumps 5 of the semiconductor integrated circuit 21, in order that a wiring 84 is led out of the area array from a land 22 on a more inner side, the wiring 84 needs to pass between lands 22 on a more outer side. For that reason, significantly minute wirings 84 become necessary. Fig. 30B shows an example where wirings 84 are lead out from lands 22 on the outermost side, and lands 22 on the second line and on the third line from the outermost side.

The minimum dimension of a land pitch is represented by the following (Formula 1):

$$\text{The minimum dimension} = (\text{width of wiring} \times n) + (\text{space between}$$

$$\text{wirings} \times (n+1)) + \text{diameter of lands} \qquad \text{(Formula 1)},$$

where n denotes the number of wirings between lands.

From (Formula 1), it is found that the minimum dimension equals 250 µm when the diameter of lands is 100 µm, the width of wiring is 30 µm, the space between wirings is 30 µm and n is 2. In this way, in the area array with a land pitch of 250 µm, the number of wirings that can be led out so as to pass between the lands 22 is at most 2. Therefore, in order to lead out more than 2 wirings in number so as to pass between the lands, there is a need to narrow the width of wiring and the space between wirings, or to reduce the diameter of lands.

However, it is difficult to further narrow the width of wiring and the space between wirings. The diameter of lands needs to be made large to allow the alignment with the bumps 5 of the semiconductor integrated circuit 21 and the connection with the bumps 5 with high reliability and stability.

Furthermore, in terms of a relationship with the via hole conductors 83 also, the diameter of lands need to be made large. When a reduction in diameter of lands is attempted, a diameter of the via hole conductors 83 that connects wiring layers also needs to be decreased. When the diameter of the via hole conductors 83 is decreased to 50 μm or less, since the thickness of the insulation layer in the conventional resin board is 50 to 100 μm, its aspect ratio becomes more than 1. Thus, there is a problem of the difficulty in securing the stable connection and the reliability because of a deterioration occurring from a stress due to heat cycle and the like in the via hole connection that is minute and has a large aspect ratio, as well as the difficulty in processing of minute holes.

On the other hand, in the wiring board 100EX of Embodiment 15 shown in Fig. 29A and Fig. 29B, the thickness of each of the conductive layers and the insulation layers is small, and therefore even when the via hole conductor penetrates through a plurality of insulation layers, the length of the via hole conductor in a thickness direction can be shortened.

Furthermore, the wiring board 100EX allows lands 22 in the area array to be led out successively from the outer side through each conductive layer. Therefore, these is no need of minute wirings to be routed between the lands 22. Therefore, there is no need to decrease the diameter of lands, thus allowing an increase in the diameter of the via hole conductors. In this way, the wiring board 100EX allows the length of the via hole conductors in a thickness direction to be shortened, as well as the diameter of the via holes to be increased. As a result, the aspect ratio of the via hole conductors can be reduced.

In the example shown in Fig. 29A, the via hole diameter is 100 μm, and the total thickness of the wiring board 100EX is 20 μm. Therefore, the total thickness of the wiring board 100EX is far smaller than the via hole diameter. Thus, since the aspect ratio of the via hole conductors becomes small, the reliability of the via hole conductors and the via hole connection can be secured easily.

For instance, in the case where the via hole diameter is 100 μm, and ten insulation layers each having a thickness of 5 μm and eleven conductive layers each having a thickness of 4 μm are laminated, a length of the via holes, even in the case of the longest one in the thickness direction, is about 90 μm. Thus, its aspect ratio is smaller than 1. Therefore, the via hole connection that can be manufactured easily and has a high reliability can be realized.

In addition, by further increasing the number of laminated layers using still thinner insulation layers and conductive layers, the connection with a larger number of pins can be established easily. Even in this case, the aspect ratio of the via hole conductors can be made smaller than 1, and therefore the via hole connection with stability and a high reliability can be realized.

Also, in the wiring board 100EX of Embodiment 15, there is no need to make the width of wirings minute. For instance, assuming that a pitch of the lands 22 in the area array is 250 μm, a diameter of the lands 22 is 150 μm and a diameter of the via holes 100 μm, then there is no need for the wirings to be routed between the lands 22 as in the above-described conventional resin board, but the wirings can be led out from the lands 22 directly to the outside. Therefore, even the wirings with a width of 150 μm, which is the same as the land diameter, can be led out. Thus, the wirings can be manufactured more easily as compared with the conventional case. As a result, the wiring board that can be manufactured easily and has a high productivity, and is free from a deterioration of signals resulting from minute wirings and minute via hole connection, can be realized.

In Embodiment 15, a 2-μm thick aramid film is used for the insulation layers. Then, a primary coating including a copper thin film is formed thereon by sputtering, and a copper thin film is grown thereon by electroplating so as to form a conductive layer with a thickness of 1 μm. Next, a thermosetting adhesive is inserted between the respective layers, and hot pressing is conducted thereto while overlaying one layer on another, whereby the adhesive is cured so as to form a lamination member.

Therefore, since the thickness of each insulation layer is 3 μm at most, a wiring board including as many as seven conductive layers can be realized with a total thickness of about 30 μm. Note here that the lands on the lower face of the wiring board 100EX that connect with the solder balls 16 are reinforced with 18-μm thick copper foil, because a certain strength is required during the packaging of the wiring board 100EX to the mother board 15.

The via hole conductors 9A and 9B are formed as follows: firstly, via holes are bored by laser processing at predetermined positions of the upper face and the lower face of the above-described lamination member where the via hole conductors are to be formed. At the portions where the via holes are to be formed, other portions of the conductive layer extending from a surface to a predetermined conductive layer are removed beforehand, and therefore the insulation layers only remain from the surface to the predetermined conductive layer. Thus, by removing the insulation layers from the surface to the predetermined conductive layer by laser, via holes can be formed easily. Then, the via holes are filled with a conductive paste by printing, followed by heat curing so as to form the via hole conductors 9A and 9B.

In this way, according to Embodiment 15, even in the case of the via hole connection across a large number of insulation layers, for example, in the case of seven conductive layers, the semiconductor integrated circuit 21 and the mother board 15 can be connected through via hole conductors with a thickness of 30 μm and a diameter of 100 μm, which are via hole conductors that are shallow and wide, i.e., with a low aspect ratio. Therefore, the via hole connection that can be manufactured easily and has a high connection reliability can be obtained.

As shown in Fig. 29B, as for the led-out wirings in the conductive layer 1A from the lands 22 on the outermost side and the led-out wirings in the conductive layer 1B from the lands 22 on the second line from the outermost side, a large number of wirings cross each other. However, since these wirings are formed in the different conductive layer 1A and conductive layer 1B, they can be routed so as to cross each other freely.

By forming a solid-formed ground layer and power supply layer in the conductive layer 1C and the conductive layer 1E so as to protect the wirings formed in the conductive layer 1D located therebetween, disturbance radiation can be reduced and EMC can be secured.

Although Embodiment 15 shows the example of the semiconductor integrated circuit 12 as one chip, a semiconductor integrated circuit as multiple chips including MPU, memory and interface circuits also is possible. Particularly, since many wirings are necessary for the connection with the semiconductor integrated circuit as multiple chips, an increased number of wirings would be required, which means that a large number of wirings would cross each other. Therefore, the wiring board according to this embodiment having a high flexibility in wirings is especially preferable to be applied to the semiconductor integrated circuit as multiple chips.

*Embodiment 16*

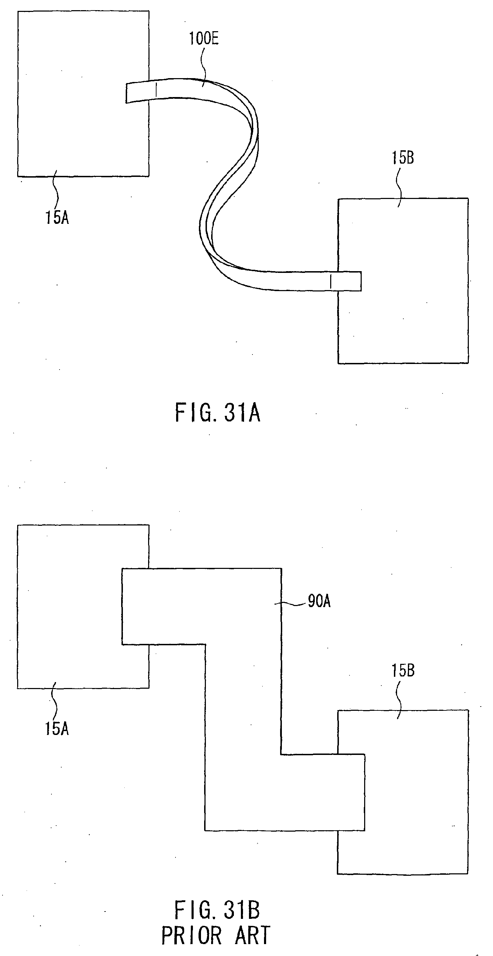

Fig. 31A is a schematic diagram for explaining a wiring board 100E according to Embodiment 16 that is for connecting mother boards 15A and 15B, and Fig. 31B is a schematic diagram for explaining a conventional wiring board 90A that is for connecting the mother boards 15A and 15B. Although the wiring board 100E is the same as the wiring board 100E described above in Embodiment 3, any one of the wiring boards according to the above-described Embodiments 1 to 15 may be used instead of the wiring board 100E.

As shown in Fig. 31B, the conventional wiring board 90A is made up of a flexible wiring board, and many wirings are formed in parallel in one layer, thus assuming a wide configuration. The wiring board 90A can be bent freely along a longitudinal direction of wirings, but lacks a flexibility in deformation in a direction perpendicular to the wirings. Therefore, as shown in Fig. 31B, this wiring board needs to be manufactured in a complicated and customized configuration depending on positions of connection portions with the mother boards 15A and 15B. Once manufactured, it is difficult to change the shape of the wiring board, and therefore there is a limitation on the arrangement of the mother boards 15A and 15B.

On the contrary, the wiring board 100E according to Embodiment 16 allows a laminated plurality of thin conductive layers to accommodate many wirings, and therefore, as shown in Fig. 31A, the wiring board can be deformed in a twisted direction like a thin cord even in the case of a linear wiring board. Thus, even when a relative relationship in arrangement between the mother boards 15A and 15B is changed, the wiring board can be deformed in accordance with such a change.

Although the conventional flexible wiring board is allowed to be deformed freely only along the longitudinal direction of the wirings, the wiring board 100E according to Embodiment 16 has a flexibility so as to follow freely a change in a relative relationship in the arrangement between the mother boards 15A and 15B, including a change in a vertical direction, a left to right direction, a front to rear direction and a twisted direction.

The conventional flexible wiring board needs to be manufactured in a predetermined configuration depending on the mounting conditions of the mother boards 15A and 15B, and therefore a customized configuration needs to be manufactured every time the configuration of equipment is changed. The wiring board according to this embodiment has a configuration like a cord and can be ready for various arrangement of the mother boards. Therefore, simply by preparing linear wiring boards satisfying standard specifications such as a length and the number of wiring layers, support for electronic equipment with various configurations can be provided.

In this way, the wiring board 100E according to Embodiment 16 can eliminate the necessity for the preparation of a customized configuration for each equipment design, and support for various arrangements of the mother boards can be provided by repeatedly manufacturing wiring boards satisfying standards specifications. Therefore, this wiring board can promote high productivity and facilitate mass production.

As is evident from the above-stated Embodiments 1 to 16, a thickness of the conductive layers can be formed so as to have a considerably small aspect ratio in a cross section of the conductive layers, and therefore a conductor loss due to an increase in impedance based on the skin effect of the conductor, which becomes a problem when high frequency signals are to be transmitted, can be avoided.

Furthermore, an area of the wiring board can be made smaller and the number of wirings formed can be increased, as compared with the conventional one. Therefore, in mobile electronic equipment that is required to be compact and lightweight, the wiring board of the present invention is significantly effective for the use of the connection with a circuit board in which a large number of input/output terminals are arranged with a high density so as to seek multifunctional equipment.

When the above-described thin film multilayered wiring board of each of Embodiments 1 to 16 of the present invention is used for electronic equipment including two constituting members that undergo folding operations frequently as found in a compact and lightweight mobile electronic equipment such as a notebook computer and a mobile phone, circuit boards that are separately held in the two constituting members can be connected electrically with each other while being bent freely without directionality and having a high connection reliability.

In the respective drawings referred to in the above-stated Embodiments 1 to 16, the thickness direction is relatively enlarged and shown for the clarity of the cross-sectional shape of the lamination structure of the conductive layers and the insulation layers. Therefore, the actual thickness in cross-section in each of the embodiments is considerably small. An aspect ratio of the conductive layers constituting the signal wirings is considerably smaller than an aspect ratio of the conventional wiring board, and an aspect ratio of the insulation layers also is considerably small. Therefore, the total thickness of the lamination in which a considerably large number of layers are laminated is smaller than 200 μm. Furthermore, actually, aspect ratios of the via hole conductors and the bumps also are relatively smaller than 1.

The present invention is applicable to a wiring board that connects electrically circuit boards mutually, a manufacturing method for the same, and electronic equipment using the same.

**Claims**

1. A wiring board, comprising:

    a plurality of conductive layers each including one or more wirings for transmitting signals; and
    a plurality of insulation layers for insulating the respective conductive layers;

    wherein the conductive layers and the insulation layers are laminated alternately, and
    each of the plurality of conductive layers is provided with a terminal at at least one of both ends,
    wherein the terminals are formed stepwise and separated by the insulation layers in a cross-sectional shape of a lamination structure of the conductive layers and the insulation layers.

2. The wiring board according to claim 1, wherein the conductive layers and the insulation layers are formed in an atmosphere at a reduced pressure below the atmospheric pressure.

3. The wiring board according to claim 1, wherein the plurality of conductive layers are three or more thin film conductive layers.

4. The wiring board according to claim 1, wherein one or more conductive layers among the plurality of conductive layers comprise a plurality of wirings.

5. The wiring board according to claim 1, wherein the number of wirings included in one of the plurality of conductive layers and the number of wirings included in another conductive layer of the plurality of conductive layers are different from each other.

6. The wiring board according to claim 1, wherein at least two conductive layers among the plurality of conductive layers comprise a shield layer for shielding a wiring in another conductive layer sandwiched between the two conductive layers.

7. The wiring board according to claim 1,
    wherein one or more conductive layers among the plurality of conductive layers comprise a plurality of wirings, and
    each of the plurality of wirings comprises the terminal.

8. The wiring board according to claim 1, wherein the terminals are arranged stepwise from a conductive layer laminated at the center toward conductive layers on both sides.

9. The wiring board according to claim 1, wherein the terminals are arranged in any one of manners that are along one vertical line, along one horizontal line and in a matrix form, when viewing from a lamination direction of the conductive layers and the insulation layers.

10. The wiring board according to claim 1, wherein the terminals are arranged along a direction oblique to a longitudinal direction of the wirings, when viewing from a lamination direction of the conductive layers and the insulation layers.

11. The wiring board according to claim 1, wherein the terminals are arranged in a V-letter shape, when viewing from a lamination direction of the conductive layers and the insulation layers.

12. The wiring board according to claim 1, wherein the terminals each have a thickness larger than the conductive layer that is covered with the insulation layer.

13. The wiring board according to claim 1, wherein bumps are formed on the respective terminals.

14. The wiring board according to claim 13,
   wherein each of the bumps has an electric connection face at its tip end, and
   the respective electric connection faces are formed to be coplanar.

15. The wiring board according to claim 1, further comprising:

   a protective layer that covers the terminals;
   via hole conductors that are formed in the protective layer and connect with the respective terminals; and
   a plurality of electrodes that are formed on a surface of the protective layer and connect with the respective via hole conductors.

16. The wiring board according to claim 1,
   wherein each of the terminals is formed so as to protrude and has an electric connection face at its tip end, and
   the respective electric connection faces are formed so as to be coplanar.

17. The wiring board according to claim 1, wherein the conductive layers and the insulation layers are formed by at least one of a vapor deposition method, a sputtering method and a CVD method.

18. A method for manufacturing a wiring board, the wiring board comprising: a plurality of conductive layers each including one or more wirings for transmitting signals; and a plurality of insulation layers for insulating the respective conductive layers; wherein the conductive layers and the insulation layers are laminated alternately, and each of the plurality of conductive layers is provided with a terminal at at least one of both ends,
   wherein the method comprises the step of forming the terminals stepwise and separated by the insulation layers in a cross-sectional shape of a lamination structure of the conductive layers and the insulation layers.

19. The method for manufacturing a wiring board according to claim 18, wherein the terminals are formed by plating while feeding electricity to the conductive layers at one end.

20. The method for manufacturing a wiring board according to claim 18,
   wherein each of the terminals is made up of a bump,
   wherein masking is applied to the conductive layers at one end using a mask having an aperture, and
   the bumps are formed by plating through the aperture of the mask while feeding electricity to the masked conductive layers at the one end.

21. The method for manufacturing a wiring board according to claim 18,
   wherein each of the terminals is made up of a bump, and
   the bumps are formed by depositing a conductor at one end of the conductive layers.

22. The method for manufacturing a wiring board according to claim 20 or 21, wherein a pressure is applied to tip ends of the respective bumps with flat plates so that the bumps are uniform in height to be coplanar.

23. A method for manufacturing a wiring board, the wiring board comprising: a plurality of conductive layers each including one or more wirings for transmitting signals; and a plurality of insulation layers for insulating the respective conductive layers, wherein the conductive layers and the insulation layers are laminated alternately,
   wherein the method comprises the step of forming the conductive layers and the insulation layers in an atmosphere at a reduced pressure below the atmospheric pressure.

24. Electronic equipment, comprising:

a plurality of circuit boards; and
a wiring board that connects the circuit boards,

wherein the wiring board is one according to claim 1.

100

2

1

2

1

2

## FIG. 1A

100

2

1

## FIG. 1B

100A

1

2

2

1

FIG. 2

100B

3AA   3AB   3AC   3AD

2

1

1PA

1PB

1PC

1PD

1PE

2

3BA   3BB   3BC   3BD   3BE

FIG. 3

FIG. 4A

FIG. 4B

100D

2 ⌐ 1

FIG. 5

100E

2A 1AT 2 2 2

1BT
1CT
1DT
1ET
1FT
1GT

1A
1B
1C
1D
1E
1F
1G

2

FIG. 6A

100E

2A 2A 2A 2

1GT 1ET 1CT 1AT
1FT 1DT 1BT

FIG. 6B

FIG. 6C

FIG. 6D

FIG. 6E

100E4

FIG. 6F

FIG. 7A

FIG. 7B

EP 1 465 471 A2

100G

8B →

1GAT

1GBT

1GCT

1GDT

1GET

1GFT

2

8B →

2

FIG. 8A

100G

1GAT 1GBT 1GCT 1GDT 1GET 1GFT

2

1GA
1GB
1GC
1GD
1GE
1GF

2

FIG. 8B

1HET  1HCT  1HAT

2

100H

9B

2  1HDT  1HBT

9B

FIG. 9A

100H

1HBT  1HAT  2  2

1HCT

1HDT

1HET

1HA
1HB
1HC
1HD
1HE

2

FIG. 9B

FIG. 10A

FIG. 10B

FIG. 11

FIG. 12A

FIG. 12B

100L

1LBT  1LDT  1LFT  1LHT  2

2

1LAT  1LCT  1LET  1LGT

FIG. 13A

100M

1MCT  1MET

1MBT  1MDT  1MDT  1MFT  2

2

1MAT

1MBT  1MDT  1MET  1MHT

1MCT  1MGT

FIG. 13B

100N

1NAT  2  2

1NBT

1NCT

1NDT

1NET

1NFT

1NGT

1NA
1NB
1NC
1ND
1NE
1NF
1NG

2

FIG. 14

FIG. 15

FIG. 16

1GTX 1FTX 1ETX 1DTX 1CTX 1BTX    2A

1ATX

100EX

2    2

1A
1B
1C
1D
1E
1F
1G

2

FIG. 17A

100EX

1GTX    1ETX    1CTX    1ATX
       2A      2A

2

2

1FTX    1DTX    1BTX

FIG. 17B

FIG. 18

100GX

19B →

1GATX
1GBTX
1GCTX
1GDTX
1GETX
1GFTX
2

19B →

2

FIG. 19A

100GX

1GATX   1GCTX   1GETX
2   1GBTX   1GDTX   1GFTX
1GA
1GB
2
1GC
1GD
1GF
1GE

2

FIG. 19B

100HX

1HETX 1HCTX 1HATX

2

20B

20B

2 1HDTX 1HBTX

FIG. 20A

100HX

1EDTX 1HCTX 1HBTX 1HATX

1HETX

2 2

2

1HA
1HB
1HC
1HD
1HE

FIG. 20B

FIG. 21A

36aT  36bT  36cT  36dT  36eT

1001X

107
106
105
104
103
102
101

FIG. 21B

32cT  33cT  34cT  35cT  36cT  37cT  38cT

1001X

107
106
105
104
103
102
101

FIG. 21C

100JX

32aT

32bT

32cT

32dT

32eT

101 102 103 104 105 106 107

FIG. 22

F I G. 23A

F I G. 23B

FIG. 24A

FIG. 24B

FIG. 25

FIG. 26

FIG. 27A

FIG. 27B

FIG. 27C

FIG. 28A

FIG. 28B

FIG. 28C

FIG. 28D

FIG. 29A

FIG. 29B

FIG. 30A
PRIOR ART

FIG. 30B
PRIOR ART

FIG. 31A

FIG. 31B
PRIOR ART

FIG. 32
PRIOR ART

FIG. 33
PRIOR ART